# EUROPEAN PATENT APPLICATION

(11) **EP 4 589 472 A1**
(43) Date of publication of application: **23.07.2025**
(21) Application number: 23876213.2
(22) Date of filing: 21.06.2023
(51) Int. Cl.: G06N 3/00

(54) **SIMULATION TRAINING METHOD AND APPARATUS, AND COMPUTING DEVICE CLUSTER**

(30) Priority: 10.10.2022 CN 202211237632
(71) Applicant: Huawei Cloud Computing Technologies Co., Ltd., Guiyang, Guizhou 550025 (CN)
(72) Inventor: ZHOU, Shunbo, Guiyang, Guizhou 550025 (CN); REN, Hang, Guiyang, Guizhou 550025 (CN); XU, Qiaobo, Guiyang, Guizhou 550025 (CN); WANG, Feng, Guiyang, Guizhou 550025 (CN)
(74) Representative: Körber, Martin Hans
(86) International application number: PCT/CN2023/101580
(87) International publication number: WO 2024/078003

(57) **Abstract**

A simulation training method and apparatus, and a computing device cluster are provided. In embodiments, the method is applied to a cloud management platform and includes: providing a first configuration interface, where the first configuration interface is configured to obtain an identifier of a target simulation environment and an identifier of a target simulation device; providing a second configuration interface, where the second configuration interface is configured to obtain a task instruction; and executing, by using the target simulation device, a task according to the task instruction in the target simulation environment, to obtain an execution result. Therefore, simulation of a mobile device and an environment in which the mobile device is located can be implemented on a cloud, and the cloud executes, by using a simulation device configured by a user and in a simulation environment configured by the user, a task configured by the user, to implement intelligent task execution.

## Description

This application claims priority to Chinese Patent Application No. 202211237632.0, filed with the China National Intellectual Property Administration on October 10, 2022 and entitled "SIMULATION TRAINING METHOD AND APPARATUS, AND COMPUTING DEVICE CLUSTER", which is incorporated herein by reference in its entirety.

### TECHNICAL FIELD

This application relates to the field of simulation technologies, and in particular, to a simulation training method and apparatus, and a computing device cluster.

### BACKGROUND

Currently, during implementation of a robot, a virtual robot is applied more widely. In some dangerous, dirty, tedious, or challenging application scenarios, a requirement for a virtual robot to execute a task is also higher.

A solution for a virtual robot to execute a task in the conventional technology is not intelligent enough, and cannot meet a user requirement. How to construct an execution solution for a virtual robot is a problem to be urgently resolved currently.

### SUMMARY

Embodiments of this application provide a simulation training method and apparatus, and a computing device cluster, so that simulation of a mobile device and an environment in which the mobile device is located can be implemented on a cloud, and the cloud executes, by using a simulation device configured by a user and in a simulation environment configured by the user, a task configured by the user, to implement intelligent task execution.

According to a first aspect, an embodiment of this application provides a simulation training method, applied to a cloud management platform. The method includes: providing a first configuration interface, where the first configuration interface is configured to obtain an identifier of a target simulation environment and an identifier of a target simulation device; providing a second configuration interface, where the second configuration interface is configured to obtain a task instruction; and executing, by using the target simulation device, a task according to the task instruction in a simulation scenario, to obtain an execution result.

In this solution, simulation of a mobile device and an environment in which the mobile device is located can be implemented on a cloud, and the cloud executes, by using the simulation device configured by a user and in a simulation environment configured by the user, a task configured by the user, to implement intelligent task execution.

In a possible implementation, before obtaining the identifier of a target simulation scenario, the method includes: obtaining collected data corresponding to the target simulation environment; providing a third configuration interface, where the third configuration interface is configured to obtain a type parameter of the target simulation environment; and generating the target simulation environment based on the collected data corresponding to the target simulation environment and the type parameter of the target simulation environment.

In this solution, simulation can be performed based on a type of the environment, to ensure that the simulation environment can be similar to a real environment.

In an example, the type parameter includes one or more of the following: an indoor scenario, an outdoor scenario, and a weather type.

In an example, the collected data corresponding to the target environment includes data perceived by a mobile device and/or a field device in a real environment corresponding to the target environment.

In a possible implementation, the target environment includes at least one three-dimensional model and a physical parameter corresponding to each of the at least one three-dimensional model, and the executing, by using the target simulation device, a task according to the task instruction in the target simulation environment includes: executing, by using the target simulation device and the physical parameter of the at least one three-dimensional model, the task according to the task instruction in the target simulation environment.

In this solution, the task can be executed based on the physical parameter of an object in the simulation environment, to ensure that the task execution result can be similar to a real task execution result.

In an example, the physical parameter is determined based on the collected data corresponding to the target environment.

In an example, the physical parameter includes a friction coefficient and/or a drag coefficient.

In a possible implementation, the second configuration interface is further configured to obtain a quantity of processes corresponding to the task.

In this solution, the quantity of processes can be set, to implement parallel task execution and ensure task execution efficiency.

In a possible implementation, the task includes a start point and an end point, and the second configuration interface is further configured to obtain the start point and the end point that are set by a user.

In a possible implementation, obtaining the identifier of the target simulation environment includes: the first configuration interface is configured to obtain the identifier of the target simulation environment selected by the user from a plurality of candidate simulation environments.

In an example, the plurality of candidate environments are separately determined based on collected data corresponding to each of the plurality of candidate environments, and the collected data includes data perceived by a mobile device and/or a field device in a corresponding real environment.

In a possible implementation, obtaining the identifier of the target simulation device includes: the first configuration interface is configured to obtain the identifier of the target simulation device selected by the user from a plurality of candidate simulation devices.

In an example, the plurality of candidate devices include a preset candidate device or a candidate device generated by modeling based on appearance data of a real device.

In a possible implementation, the method further includes: delivering the execution result to a target device corresponding to the simulation device.

In a possible implementation, the executing, by using the target simulation device, a task according to the task instruction in the target simulation environment includes: converting the task instruction into a simulation instruction based on semantic recognition, where the simulation instruction is in a computer-readable format; and executing, by using the target simulation device, the task according to the simulation instruction in the target simulation environment.

In a possible implementation, the task includes at least one skill.

In an example, the skill includes navigation, the execution result includes a motion trajectory, and the method further includes displaying the motion trajectory.

In an example, the target simulation device includes at least one joint, and the at least one joint corresponds to a dynamics parameter. The executing, by using the target simulation device, a task according to the task instruction in the target simulation environment includes: controlling, by using the dynamics parameter of the at least one joint in the target simulation device and according to the task instruction, the target simulation device to execute the task in the target simulation environment.

In this solution, the simulation device can be controlled to execute the task based on the dynamics parameter of the joint in the simulation device, to ensure that the task execution result can be similar to a real task execution result.

In an example, the method further includes: displaying resources consumed by each of the at least one skill during execution.

In an example, the method further includes: determining a target skill that is of the at least one skill and that is deployed on the target device corresponding to the target simulation device.

In a possible implementation, the task includes a prediction indicator, and the execution result includes a value of the prediction indicator.

In an example, the prediction indicator includes a temperature threshold, a running duration threshold, and a battery level threshold of a component in the target device corresponding to the target simulation device.

In a possible implementation, the target environment in the simulation scenario has semantic information.

In a possible implementation, the task includes a prediction indicator, and the execution result includes a value of the prediction indicator.

In a possible implementation, the first configuration interface is configured to obtain an identifier of a static simulation object, a first location of the static simulation object in the target simulation environment, and/or an identifier of a dynamic simulation object, and a second location of the dynamic simulation object in the target simulation environment.

The first location in the target simulation environment includes the static simulation object, and the second location includes the dynamic simulation object.

According to a second aspect, an embodiment of this application provides a simulation training apparatus, used in a cloud management platform. The apparatus includes:
a first interface providing module, configured to provide a first configuration interface, where the first configuration interface is configured to obtain an identifier of a target simulation environment and an identifier of a target simulation device;
a second interface providing module, configured to provide a second configuration interface, where the second configuration interface is configured to obtain a task instruction; and
a task execution module, configured to execute, by using the target simulation device, a task according to the task instruction in a simulation scenario, to obtain an execution result.

In a possible implementation, the apparatus further includes an environment generation module, where the environment generation module includes a data collection unit, an interface providing unit, and a generation unit.

The data collection unit is configured to obtain collected data corresponding to the target simulation environment.

The interface providing unit is configured to provide a third configuration interface, where the third configuration interface is configured to obtain a type parameter of the target simulation environment.

The generation unit is configured to generate the target simulation environment based on the collected data corresponding to the target simulation environment and the type parameter of the target simulation environment.

In an example, the type parameter includes one or more of the following: an indoor scenario, an outdoor scenario, and a weather type.

In an example, the collected data corresponding to the target simulation environment includes data perceived by a mobile device and/or a field device in a real environment corresponding to the target simulation environment.

In a possible implementation, the target simulation environment includes at least one three-dimensional model and a physical parameter corresponding to each of the at least one three-dimensional model, and the task execution module is configured to execute, by using the target simulation device and the physical parameter of the at least one three-dimensional model, the task according to the task instruction in the target simulation environment.

In an example, the physical parameter is determined based on the collected data corresponding to the target environment.

In an example, the physical parameter includes a friction coefficient and/or a drag coefficient.

In a possible implementation, the second configuration interface is further configured to obtain a quantity of processes corresponding to the task.

In a possible implementation, the task includes a start point and an end point, and the second configuration interface is further configured to obtain the start point and the end point that are set by a user.

In a possible implementation, the first configuration interface is configured to obtain the identifier of the target simulation environment selected by the user from a plurality of candidate simulation environments.

In a possible implementation, the first configuration interface is configured to obtain the identifier of the target simulation device selected by the user from a plurality of candidate simulation devices.

In an example, the plurality of candidate simulation devices include a preset candidate simulation device or a candidate simulation device generated by modeling based on appearance data of a real device.

In a possible implementation, the apparatus further includes a delivering module, where the delivering module is configured to deliver the execution result to a target device corresponding to the target simulation device.

In a possible implementation, the task execution module is configured to: convert the task instruction into a simulation instruction based on semantic recognition, where the simulation instruction is in a computer-readable format; and execute, by using the target simulation device, the task according to the simulation instruction in the target simulation environment.

In a possible implementation, the task includes at least one skill.

In an example, the skill includes navigation, the execution result includes a motion trajectory, and the method further includes displaying the motion trajectory.

In an example, the simulation device includes at least one joint and a dynamics parameter corresponding to each of the at least one joint, and the task execution module is configured to control, by using the dynamics parameter of the at least one joint in the target simulation device, the target simulation device to execute the task in the simulation scenario.

In an example, the apparatus further includes a display module, where the display module is configured to display resources consumed by each of the at least one skill during execution.

In an example, the apparatus further includes a deployment module, where the deployment module is configured to determine a target skill that is of the at least one skill and that is deployed on the target device corresponding to the target simulation device.

In a possible implementation, the task includes a prediction indicator, and the execution result includes a value of the prediction indicator.

In an example, the prediction indicator includes a temperature threshold, a running duration threshold, and a battery level threshold of a component in the target device corresponding to the target simulation device.

In a possible implementation, the target environment in the simulation scenario has semantic information.

In a possible implementation, the task includes a prediction indicator, and the execution result includes a value of the prediction indicator.

In a possible implementation, the first configuration interface is configured to obtain an identifier of a static simulation object, a first location of the static simulation object in the target simulation environment, and/or an identifier of a dynamic simulation object, and a second location of the dynamic simulation object in the target simulation environment.

The first location in the target simulation environment includes the static simulation object, and the second location includes the dynamic simulation object.

According to a third aspect, an embodiment of this application provides a simulation training apparatus, including: at least one memory, configured to store a program; and at least one processor, configured to execute the program stored in the memory. When the program stored in the memory is executed, the processor is configured to perform the method provided in the first aspect.

According to a fourth aspect, an embodiment of this application provides a simulation training apparatus, where the apparatus runs computer program instructions, to perform the method provided in the first aspect. For example, the apparatus may be a chip or a processor.

In an example, the apparatus may include a processor. The processor may be coupled to a memory, read instructions in the memory, and perform, based on the instructions, the method provided in the first aspect. The memory may be integrated into a chip or a processor, or may be independent of the chip or the processor.

According to a fifth aspect, an embodiment of the present invention provides a computing device cluster, including at least one computing device, where each computing device includes a processor and a memory, and the processor of the at least one computing device is configured to execute instructions stored in the memory of the at least one computing device, so that the computing device cluster is enabled to perform the method provided in the first aspect.

According to a sixth aspect, an embodiment of this application provides a computer storage medium, where the computer storage medium stores instructions, and when the instructions are run on a computer, the computer is enabled to perform the method provided in the first aspect.

According to a seventh aspect, an embodiment of this application provides a computer program product including instructions. When the instructions are run on a computer, the computer is enabled to perform the method provided in the first aspect.

### BRIEF DESCRIPTION OF DRAWINGS

FIG. 1 is a system architectural diagram of a cloud system according to an embodiment of this application;
FIG. 2 is a diagram of a cloud scenario according to an embodiment of this application;
FIG. 3 is a schematic flowchart 1 of a simulation training method according to an embodiment of this application;
FIG. 4 is a schematic flowchart 2 of a simulation training method according to an embodiment of this application;
FIG. 5a is a diagram of a model configuration page according to an embodiment of this application;
FIG. 5b is a diagram of a task orchestration page according to an embodiment of this application;
FIG. 6a is a diagram of edge-cloud synergy in a campus patrol scenario according to an embodiment of this application;
FIG. 6b is a diagram of edge-cloud synergy in a cabin hospital scenario according to an embodiment of this application;
FIG. 7 is a diagram of a structure of a simulation training apparatus according to an embodiment of this application;
FIG. 8 is a diagram of a structure of a computing device according to an embodiment of the present invention;
FIG. 9 is a diagram of a structure of a computing device cluster according to an embodiment of the present invention; and
FIG. 10 is a diagram of an application scenario of a computing device cluster according to FIG. 9.

### DESCRIPTION OF EMBODIMENTS

To make objectives, technical solutions, and advantages of embodiments of this application clearer, the following describes the technical solutions in embodiments of this application with reference to accompanying drawings.

In descriptions of embodiments of this application, the word such as "example", "for example", or "for instance" is used to represent an example, an illustration, or a description. Any embodiment or design solution described as "example", "for example", or "for instance" in embodiments of this application should not be interpreted as being more preferred or having more advantages than another embodiment or design solution. Specifically, use of the word such as "example", "for example", or "for instance" is intended to present a related concept in a specific manner.

In descriptions of embodiments of this application, the term "and/or" is merely an association relationship for describing associated objects, and indicates that three relationships may exist. For example, A and/or B may indicate: only A exists, only B exists, and both A and B exist. In addition, unless otherwise specified, the term "a plurality of" means two or more. For example, a plurality of systems means two or more systems, and a plurality of terminals means two or more terminals.

In addition, the terms "first" and "second" are merely intended for a purpose of descriptions, and shall not be understood as an indication or implication of relative importance or implicit indication of indicated technical features. Therefore, a feature limited by "first" or "second" may explicitly or implicitly include one or more features. The terms "include", "contain", "have", and their variants all mean "include but are not limited to", unless otherwise specifically emphasized in another manner.

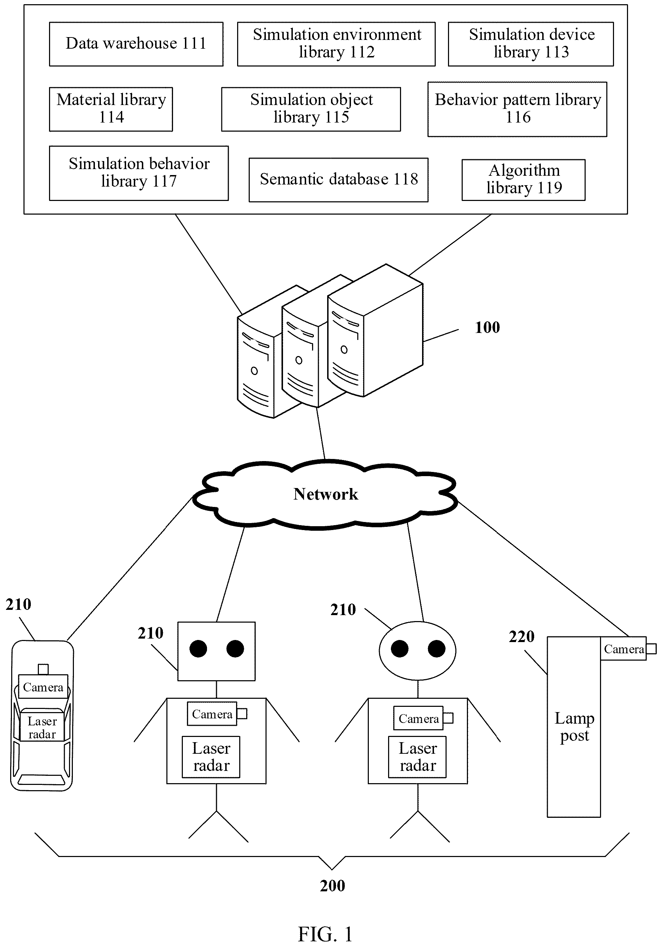

FIG. 1 is an architectural diagram of a cloud system according to an embodiment of the present invention. As shown in FIG. 1, the system includes a cloud server cluster 100, an edge device 200, and a terminal device 300.

The cloud server cluster 100 may be implemented by using an independent electronic device or a device cluster including a plurality of electronic devices. Optionally, the electronic device in the cloud server cluster 100 may be a terminal, a computer, or a server. In an example, the server in this solution may be configured to provide a cloud service, and may be a server or a hyper terminal that can establish a communication connection to another device and can provide a computing function and/or a storage function for the another device. The server in this solution may be a hardware server, or may be embedded in a virtualized environment. For example, the server in this solution may be a virtual machine executed on a hardware server including one or more other virtual machines.

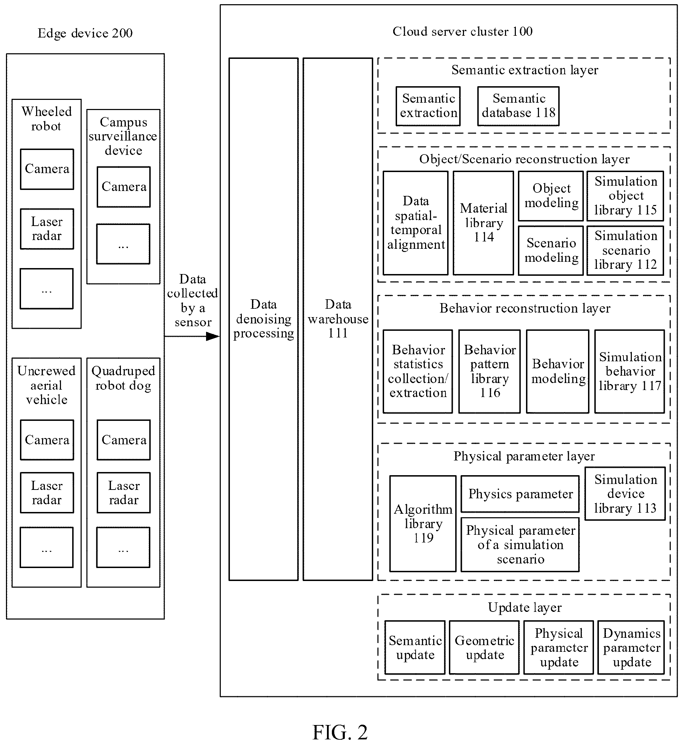

The edge device 200 may be a mobile device 210 or a field device 220. The mobile device 210 may be a robot, a vehicle or a device that can be moved, and a sensor, for example, a camera (camera) or a laser radar (Laser Radar), is installed on the mobile device 210. The field device 220 may be a sensor installed on a lamp post, for example, a camera (camera), a laser radar (Laser Radar), a thermometer, a hygrometer, or the like. FIG. 2 is a diagram of a cloud scenario according to an embodiment of the present invention. As shown in FIG. 2, the mobile device 210 may be a wheeled robot, an uncrewed aerial vehicle, a quadruped robot dog, or the like, and the field device 220 may be a campus surveillance device.

The terminal device 300 may be but is not limited to a personal computer, a notebook computer, a smartphone, a tablet computer, and a portable wearable device. An example embodiment of the terminal device 300 in this solution includes but is not limited to an electronic device with iOS, Android, Windows, Harmony OS (Harmony OS), or another operating system. A type of the electronic device is not specifically limited in this embodiment of the present invention.

The edge device 200 is separately connected to the cloud server cluster 100 by using a network, so that data collected by a sensor on the edge device 200 can be uploaded to the cloud server cluster 100. The network may be a wired network or a wireless network. For example, the wired network may be a cable network, an optical network, a digital data network (Digital Data Network, DDN), or the like. The wireless network may be a telecommunication network, an internal network, an internet, a local area network (Local Area Network, LAN), a wide area network (Wide Area Network, WAN), a wireless local area network (Wireless Local Area Network, WLAN), a metropolitan area network (Metropolitan Area Network, MAN), a public switched telephone network (Public Switched Telephone Network, PSTN), a bluetooth network, a ZigBee (ZigBee) network, a global system for mobile communications (Global System for Mobile Communications, GSM), a CDMA (Code Division Multiple Access) network, a CPRS (General Packet Radio Service) network, or any combination thereof. It may be understood that the network may use any known network communication protocol to implement communication between different client layers and gateways. The network communication protocol may be a wired or wireless communication protocol, for example, an ethernet, a universal serial bus (universal serial bus, USB), a firewire (firewire), a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-CDMA), long-term evolution (long-term evolution, LTE), new radio (new radio, NR), bluetooth (bluetooth), wireless fidelity (wireless fidelity, Wi-Fi), or another communication protocol.

As shown in FIG. 1, the cloud server cluster 100 includes a data warehouse 111, a simulation environment library 112, a simulation device library 113, a material library 114, a simulation object library 115, a behavior pattern library 116, a simulation behavior library 117, a semantic database 118, and an algorithm library 119.

The data warehouse 111 is configured to store data obtained through performing processing on data in a plurality of formats received by the edge device 200. The processing may be data denoising, spatial-temporal alignment, and the like. The data is multi-source data in a plurality of formats, for example, a lidar point cloud (supporting ply (Polygon File Format, polygon file format), pcd (Point Cloud Data, a file format for storing point cloud data), e57 (a 3D image data file format standard that integrates point clouds and images), and another mainstream format), a video (mp4, rmvb (Real Media Variable Bit Rate, real media variable bit rate), mkv (a media file of Matroska, where Matroska is a new multimedia encapsulation format, also referred to as a multimedia container (Multimedia Container)), avi (Audio Video Interleaved, audio video interleaved format), and another mainstream format), an image (jpeg (Joint Photographic Experts Group, joint photographic experts group), jpg (a standard defined by the joint photographic experts group for continuous tone static image compression), bmp (Bitmap, bitmap), png (Portable Network Graphics, portable network graphics), and another mainstream format), robot body model data (txt, xml (Extensible Markup Language, extensible markup language), xlsx, json (JavaScript Object Notation, JavaScript object notation), and another mainstream format).

The simulation environment library 112 is configured to store an identifier corresponding to a simulation scenario (for example, may be a storage address of the simulation scenario), and the simulation scenario includes description information corresponding to each of a plurality of three-dimensional models. The description information may include geometric information (information that may form a three-dimensional model), location information, a physical parameter, and texture information. The physical parameter is a parameter that affects motion, for example, a friction coefficient and/or a drag coefficient. For example, a three-dimensional model with a physical parameter in the simulation scenario may indicate the ground. The texture information may be understood as a texture (generally referred to as a material) and a pattern of an object surface, and may better represent information of the object surface, and may specifically include a material, reflectivity, a color, and the like. It should be noted that, the simulation environment may further include environment description information, and the environment description information may include a weather condition, a light condition, and a physical parameter of air. Especially for an outdoor simulation environment, light conditions and physical parameters of air in different weather conditions need to be determined, to be closer to those in a real environment. Further, the simulation environment may further include a plurality of maps, for example, a two-dimensional map, a three-dimensional map, a semantic map, a point cloud map, and the like. It should be noted that, a simulation object in a model scenario is usually an object that is fixed in the environment, for example, a tree, the ground, or a building; or a motion object that has a fixed range of activities in the environment, for example, a tiger or a lion in a zoo, or the like. It should be noted that, although the simulation environment library 112 stores the identifier corresponding to the simulation scenario, the simulation scenario is still stored in the cloud server cluster 100. The identifier may be used to read stored data of the simulation scenario from a place in which the simulation scenario is stored in the cloud server cluster 100.

The simulation device library 113 is configured to store an identifier corresponding to a simulation device (for example, may be a storage address of the simulation device). For example, the simulation device may be a robot model. The simulation device is a virtual mobile device 210 constructed by performing 1:1 geometric appearance modeling on a geometric shape, a structure, and an appearance of a physical mobile device 210, and simulating each movable smart joint (including but not limited to a motor, an accelerator, a damping parameter, and the like) of the mobile device 210; and may support model construction by using a method such as design model update and three-dimensional reconstruction. In addition, physical simulation of a sensor of the mobile device 210 is also required. The physical simulation includes physical gravity simulation, physical collision simulation, and use of a physical material for expressing physical attributes such as friction and optical reflection. The foregoing physical attributes affect a behavior of the mobile device 210 in a specific environment. The simulation device includes dynamics parameters of a plurality of joints. The dynamics parameter may include an inertia parameter, a friction parameter, and the like, and may be specifically determined based on an actual requirement. This is not specifically limited in this embodiment of the present invention. In an actual application, the simulation device may construct a model in advance by using three-dimensional software. In an example, the dynamics parameter may be a dynamics parameter of each joint that is indicated by the simulation device and that is provided by a manufacturer when the mobile device 210 is delivered from a factory. It should be noted that, although the simulation device library 113 stores the identifier corresponding to the simulation device, the simulation device is still stored in the cloud server cluster 100. The identifier may be used to read stored data of the simulation device from a place in which the simulation device is stored in the cloud server cluster 100.

The material library 114 is configured to store an identifier of a resource for constructing a simulation object or an identifier of a resource for constructing a simulation scenario (for example, may be a resource address of a simulation object). It should be noted that, although the material library 114 stores the identifier corresponding to the resource, the resource is still stored in the cloud server cluster 100. The identifier may be used to read stored data of the resource from a place in which the resource is stored in the cloud server cluster 100.

The simulation object library 115 is configured to store an identifier corresponding to a simulation object (for example, may be a storage address of the simulation object). In an actual application, the simulation object may represent any object that may exist in an actual scenario, for example, a static object. In addition, the simulation object may include description information of the object, for example, geometric information, texture information, a category, and information that may simulate a real object. It should be noted that, although the simulation object library 115 stores the identifier corresponding to the simulation object, the simulation object is still stored in the cloud server cluster 100. The identifier may be used to read the stored data of the simulation object from a place in which the simulation object is stored in the cloud server cluster 100.

The behavior pattern library 116 is configured to store an identifier of a behavior resource (for example, may be a storage address of the behavior resource). For example, the behavior resource may be a motion segment of a vehicle. For example, the behavior resource may be a motion segment of a weather change, for example, a light change, a wind speed change, or a rainfall change. The light change may be represented by a condition of an object surface, the wind speed change may be represented by shaking of the object, and the rainfall change may be represented by a photo of a rainy day. It should be noted that, although the behavior pattern library 116 stores the identifier corresponding to the behavior resource, the behavior resource is still stored in the cloud server cluster 100. The identifier may be used to read stored data of the behavior resource from a place in which the behavior resource is stored in the cloud server cluster 100.

The simulation behavior library 117 is configured to store an identifier corresponding to a simulation behavior (for example, may be a storage address of the simulation behavior). In an actual application, the simulation behavior may be associated with a simulation object. Generally, a same simulation object may have different simulation behaviors, and the same simulation object may have a plurality of simulation behaviors. Correspondingly, the identifier corresponding to the simulation behavior further needs to include an identifier of the simulation object (for example, may be a storage address of the simulation object). Herein, the simulation object may be a person, a vehicle, or an animal, and the simulation behavior may be a straight line, a curve, a circle, a turn, or the like. In addition, the simulation behavior may alternatively be a weather change. For example, the weather change may include a wind speed change (for example, the wind speed may be recorded over time), a light change (for example, the light intensity changes over time), a rainfall change (for example, the rainfall changes over time), and the like. Herein, the simulation behavior exists independently and does not need to be attached to a simulation object. It should be noted that, although the simulation behavior library 117 stores the identifier corresponding to the simulation behavior, the simulation behavior is still stored in the cloud server cluster 100. The identifier may be used to read the stored data of the simulation behavior from a place in which the simulation behavior is stored in the cloud server cluster 100.

The semantic database 118 is configured to store semantic information of a simulation object. The semantic information may be a contour, a color, a material, location information, information about whether the object is moving, a category, a surrounding object, or the like of the object. In an actual application, one semantic database 118 may store semantic information of a plurality of simulation environments.

The algorithm library 119 stores various algorithms, for example, a robot dynamics parameter identification algorithm, a drag calculation algorithm, a friction calculation algorithm, an interaction force calculation algorithm, and an artificial intelligence algorithm. Herein, the artificial intelligence algorithm may be a deep learning algorithm, a machine learning algorithm, a deep reinforcement learning algorithm, a dynamics planning algorithm, or the like. The deep learning algorithm may include a convolutional neural network (Convolutional Neural Network, CNN), a recurrent neural network (Recurrent Neural Network, RNN), a deep neural network (Deep Neural Network, DNN), a fast regional convolutional network (FastR-CNN), YOLO (You Only Look Once), a single shot multibox detector (Single Shot MultiBox Detector, SSD), a long short-term memory (LSTM, Long Short-Term Memory) network, an embedding from language model (Embedding from Language Model, ELMO), a bidirectional encoder representation from transformers (Bidirectional Encoder Representation from Transformers, BERT), generative pre-training (Generative Pre-Training, GPT), and the like.

As shown in FIG. 2, the cloud server cluster 100 implements construction and update of a simulation environment by using a semantic extraction layer, an object/scenario reconstruction layer, a behavior reconstruction layer, and a physical parameter layer.

For the semantic extraction layer, the cloud server cluster 100 may perform semantic extraction on the data in the data warehouse 131, to obtain semantic information of a plurality of simulation objects, and store the semantic information in the semantic database.

For the object/scenario reconstruction layer, the cloud server cluster 100 may perform spatial-temporal alignment on the data in the data warehouse 131, to obtain a resource that can be modeled, and store the resource in the material library 114. In one aspect, object modeling is performed based on the resources in the material library 114, and identifiers of a plurality of constructed simulation objects are stored in the simulation object library 115. In another aspect, scenario modeling is performed based on the resources in the material library, and an identifier of the constructed simulation scenario is stored in the simulation scenario library 115. Optionally, the cloud server cluster 100 may perform SLAM (Simultaneous Localization and Mapping, simultaneous localization and mapping) based on the laser point cloud data in the data warehouse 111, to generate a point cloud model, and perform grid and texture reconstruction with reference to image data that is obtained through performing spatial-temporal alignment and that is of the laser point cloud data, to obtain a simulation scenario. In addition, a semantic map of the simulation scenario may be obtained with reference to the semantic database 117.

For the behavior reconstruction layer, the cloud server cluster 100 may perform behaviors statistics collection/extraction on the data (for example, video data) in the data warehouse 131, to obtain a behavior pattern, and store the behavior pattern in the behavior pattern library 116; and then perform modeling on the behavior pattern in the behavior pattern library 116, to obtain a simulation behavior, and store an identifier of the simulation behavior in the simulation behavior library 117. For example, statistics about various similar segments of turning of the vehicle may be collected, and then the similar segments are used as behavior patterns. Then, modeling may be performed on the behavior patterns, to determine a turning speed and a driving trajectory, to obtain a simulation behavior. For example, statistics about various similar segments of a falling brick may be collected, and then the similar segments are used as behavior patterns. Then, modeling may be performed on the behavior patterns, to determine an accelerator, a motion trajectory, and the like of the falling brick, to obtain a simulation behavior.

For the physical parameter layer, for the simulation scenario, the cloud server cluster 100 may obtain physical parameters of a plurality of three-dimensional models in the simulation scenario based on a drag calculation algorithm, an interaction force calculation algorithm, or another calculation algorithm in the algorithm library 119 and with reference to motion data of the mobile device 210 and environment data of an environment in which the mobile device 210 is located in the data of the simulation scenario. In addition, for the simulation device in the simulation device library 113, the cloud server cluster 100 may further determine a dynamics parameter of each joint in the simulation device based on motion data of a real device indicated by the simulation device and a dynamics identification calculation algorithm in the algorithm library 119.

For the update layer, the cloud server cluster 100 may implement a semantic update, a geometric update, a physical parameter update, and a dynamics parameter update. It should be noted that, the geometric update may be understood as a shape update. For example, a simulation object is newly added to a simulation environment, or a simulation object in a simulation environment is deleted. After the geometric update is performed, an original simulation scenario needs to be retained, and an identifier of an updated simulation scenario is stored in the simulation scenario library 112. The semantic update may be understood as deleting description information of a simulation object, adding description information of a simulation object, and/or updating description information of a simulation object. For example, the description information of the simulation object may be updated from that there is no vehicle near the tree to that there is a vehicle near the tree. The physical parameter update may be understood as an update of a physical parameter of a specific three-dimensional model in a simulation scenario. It is assumed that friction of the ground in a campus is A. Now it rains and the ground is wet and slippery. In this case, a friction coefficient of the ground is recalculated and updated. It should be noted that, after the physical parameter is updated, an updated physical parameter needs to be stored in a corresponding simulation scenario. In addition, the physical parameter update may include an update of environment description information of a simulation environment. For example, if a simulation environment of a sunny day is constructed previously, and it is raining in a campus, the environment description information may be updated to a related case of a rainy day. It should be noted that, the environment description information needs to retain previous information, and updated environment description information is stored in a corresponding simulation scenario.

The simulation environment in this embodiment of the present invention is constructed based on data collected by a sensor (referred to as a target sensor for ease of descriptions and differentiation) on the edge device 200. In an actual application, the cloud server cluster 100 may obtain data (referred to as target data for ease of descriptions and differentiation) indicating a change in a simulation environment, implement the semantic update by using the semantic extraction layer, implement the geometric update by using object modeling or scenario modeling by using the object/scenario reconstruction layer, and implement the physical parameter update by using the physical parameter layer.

In an example, the cloud server cluster 100 may determine, based on the data collected by the target sensor in the data warehouse 111, whether the simulation environment changes; and when the environment changes, determine data (referred to as target data for ease of descriptions and differentiation) indicating a change in the simulation environment.

In an example, the mobile device 210 may determine, based on the data collected by the target sensor in the data warehouse 111, whether the simulation environment changes; and when the environment changes, determine to upload, to the cloud server cluster 100, target data indicating a change in the simulation environment, and the cloud server cluster 100 obtains the target data.

It should be noted that, in an actual application, the cloud management platform is divided into a client and a server, and the server of the cloud management platform is installed in the cloud server cluster 100. A user may install the client of the cloud management platform on the terminal device 300, or install a browser, and enter a website address in the browser to access the client of the cloud management platform.

For example, the user enters a website address in the browser to enter a login in page of the client, operates on the login in page to register an account, and manually sets an account password or is allocated an account password by the server of the cloud management platform, to obtain the account (referred to as a target account for ease of descriptions and differentiation) and the account password (referred to as a target account password for ease of descriptions and differentiation) of the client that can access the cloud management platform. Then, the user enters the target account and the target account password on the login in page to enter the client of the cloud management platform. Then, the user may use, by using the client of the cloud management platform, various services that can be provided by the server of the cloud management platform.

In an example, the user establishes a model generation task by using the terminal device 300.

For example, the user may select, from the material library 114, data uploaded by the mobile device 210 in a specific time period for model reconstruction, or upload a resource to the material library 114 by the user. The resource refers to data such as a point cloud image collected by the mobile device 210 or the user in another manner. Then the user selects, from the material library 114, data used for reconstruction. The cloud server cluster 100 may then establish a model based on the data selected by the user.

Optionally, if the data is used to reconstruct the simulation object, the established simulation object may be stored in the simulation object library 115 under the target account.

Optionally, if the data is used to reconstruct the simulation scenario, the established simulation scenario may be stored in the simulation scenario library 112 under the target account. Further, it may be further determined whether the physical parameter, the semantic information, and/or the texture information need to be determined.

For example, the user may select a behavior pattern in a specific time period from the behavior pattern library 116 for behavior reconstruction, and the established simulation behavior may be stored in the simulation behavior library 117 under the target account.

For example, the user may select a simulation environment from the simulation environment library 112, and configure whether to perform a geometric update, a semantic update, or a physical parameter update for the simulation environment.

It should be noted that, the simulation environment library 112, the simulation device library 113, the simulation object library 115, and the simulation behavior library 117 may pre-store models shared by all users; the material library 114 may pre-store resources shared by all users; and the behavior pattern library 116 may pre-store behavior segments shared by all users.

In addition, in an actual application, the data warehouse 111 may store monitoring data of the edge device 200.

An embodiment of the present invention provides a simulation training method. It may be understood that the method may be performed by any apparatus, device, platform, or device cluster that has a computing and processing capability, for example, the cloud system shown in FIG. 1. A simulation training method provided in an embodiment of the present invention is described below with reference to the cloud system shown in FIG. 1.

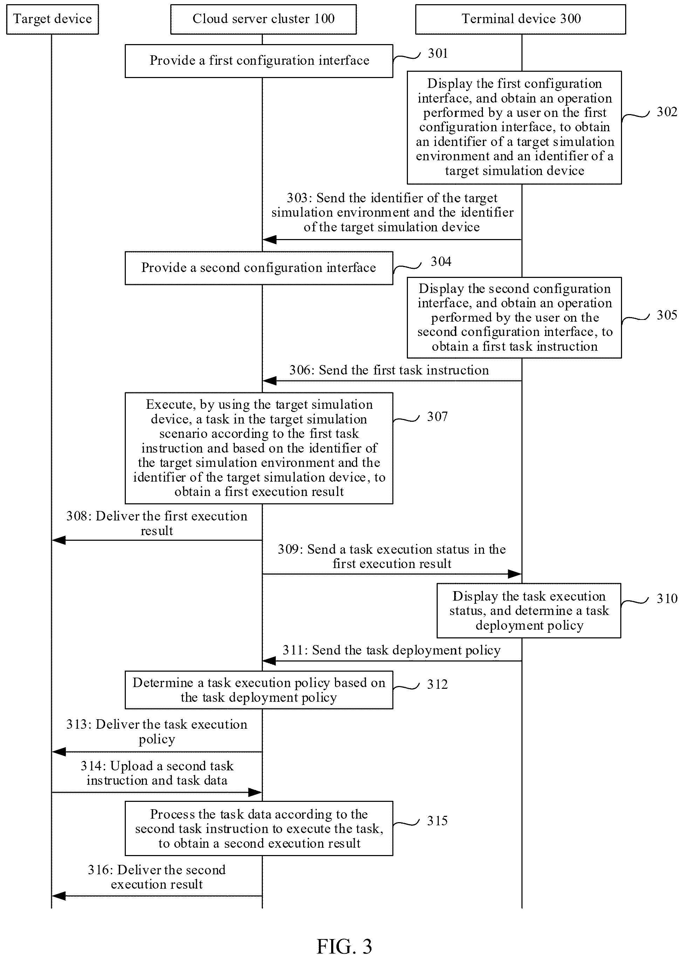

FIG. 3 is a schematic flowchart of a simulation training method according to an embodiment of the present invention. As shown in FIG. 3, the simulation training method includes the following steps.

Step 301: A cloud server cluster 100 provides a first configuration interface.

Step 302: A terminal device 300 displays the first configuration interface, and obtains an operation performed by a user on the first configuration interface, to obtain an identifier of a target simulation environment and an identifier of a target simulation device.

According to a feasible implementation, the first configuration interface may be a model configuration page. Specifically, the cloud server cluster 100 may publish the first configuration interface. Correspondingly, the terminal device 300 displays the model configuration page to the user, so that the user operates the model configuration page via the terminal device 300, determines the identifier of the target environment and the identifier of the simulation device, and uploads the identifiers to the cloud server cluster 100.

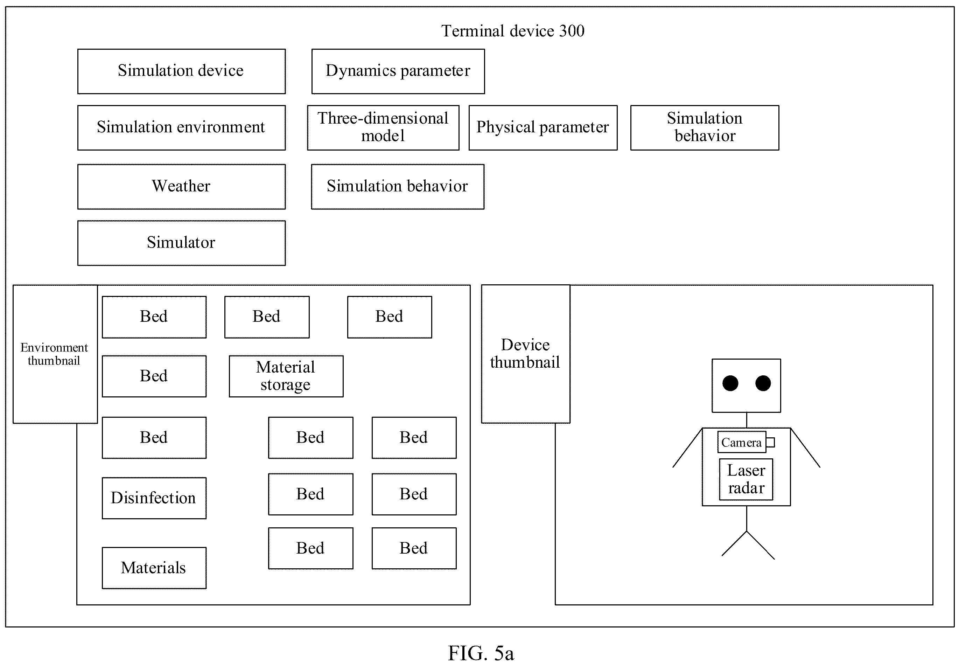

FIG. 5a is a diagram of a model configuration page according to an embodiment of this application. As shown in FIG. 5a, the model configuration page includes a simulation environment configuration control and a simulation device configuration control. In an actual application, a user enters a target account and a password on the terminal device 300 to log in to a client of a cloud management platform, and then the user operates the terminal device 300. The terminal device 300 displays the model configuration page. The user clicks the simulation environment configuration control on the model configuration page, to display a list of thumbnails of simulation environments in the simulation environment library 112 under the target account. Then the user selects a thumbnail in the list, and the first configuration interface may determine an identifier of a target simulation environment from a plurality of candidate simulation environments in the simulation environment library 112. Similarly, the user clicks the simulation device configuration control on the model configuration page, to display a list of thumbnails of simulation devices in the simulation device library 113 under the target account. Then the user selects a thumbnail in the list, and the first configuration interface may determine an identifier of a target simulation device from a plurality of candidate simulation devices in the simulation device library 113.

According to a feasible implementation, before the identifier of the target scenario is obtained, the step 302 further includes the following content:
obtain collected data corresponding to the target simulation environment; provide a third configuration interface, where the third configuration interface is configured to obtain a type parameter of the target environment; and generate the target simulation environment based on the collected data corresponding to the target simulation environment and the type parameter of the target simulation environment.

Optionally, the third configuration interface is a model generation interface. When the user establishes a model generation task on the terminal device 300 by using the model generation interface, the model generation interface includes a data configuration control and a type parameter configuration control. The data configuration control is used to select the collected data corresponding to the target simulation environment, for example, data collected by the mobile device 210 and the field device 220 from 10:00 a.m. to 10:30 a.m.; and the type parameter configuration control is used to configure the type parameter of the target simulation environment. Then the cloud server cluster 100 may generate the target simulation environment based on the data configured by the user and the type parameter of the target simulation environment.

The type parameter may include a plurality of parameters, such as an indoor scenario, an outdoor scenario, and a weather type. For example, the weather type may be a sunny day, a cloudy day, a rainy day, a cloudy day, a foggy day, a dusty day, a strong wind, or the like. It should be noted that, different type parameters have different modeling requirements. For example, in an indoor scenario, a light change generally does not need to be considered. However, in an outdoor scenario, a light change and a weather type are important, and more resources need to be consumed to simulate outdoor light. It should be noted that, in an actual application, an outdoor scenario is usually associated with a weather type. Therefore, when the type parameter is an outdoor scenario, the weather type may be directly configured. Alternatively, the weather type does not need to be configured, and the weather type may be determined based on weather forecast information and the like, to implement intelligent modeling.

The type parameter is merely used as an example, and does not constitute a specific limitation on the type parameter. In some possible embodiments, the type parameter may include more or fewer parameters than the foregoing parameters. For example, the type parameter may further include a feature complexity level, an object with a transparent feature, and a dynamic object complexity level.

The feature complexity level indicates a quantity of features of a simulation environment that need to be constructed, and a higher level indicates a larger quantity of features. Herein, the feature complexity level is used to select different feature selection methods, to reduce a difference between a constructed simulation scenario and a real scenario. For example, for a scenario with a simple feature, for example, a corridor, an optical flow method may be used to implement feature extraction. For example, in a scenario with complex features in a campus, an artificial intelligence algorithm may be used to implement feature extraction. For example, a proper artificial intelligence algorithm is selected from the algorithm library 119 to implement feature extraction. For example, the feature complexity level may be classified into three levels, for example, simple, medium, and complex. For example, the feature complexity level may be classified into five levels, for example, very simple, simple, medium, complex, and very complex. It should be noted that, based on the feature complexity level, different feature extraction methods may be selected for data collected by different sensors, or a same feature extraction method may be selected. For example, a feature may be extracted by using an artificial intelligence algorithm for both an image and laser point cloud data collected by a sensor such as a laser radar that perceives an environment in a laser manner.

The object with a transparent feature may be an object having a higher refractive index and reflectivity, for example, glass or a transparent bucket. The object has a large impact on data collected by a sensor such as a laser radar that perceives an environment in a laser manner, and may affect construction of a simulation environment, to increase a difference between the simulation environment and a real environment. In this case, data of a region in which the object with the transparent feature is located in the laser point cloud data collected by the sensor such as the laser radar that perceives the environment in the laser manner may be deleted, to reduce the difference between the simulation environment and the real environment. Herein, the region in which the object with the transparent feature is located may be perceived by using an image. In an example, the third configuration interface may be configured with a list of objects with transparent features, and the user may select an object with a transparent feature from the list, for example, glass or a transparent bucket. In an actual application, optionally, the identifier of the simulation object stored in the simulation object library 115 in the cloud server cluster 100 includes an identifier of the object with the transparent feature. In this case, the third configuration interface is associated with the identifier of the object with the transparent feature in the simulation object library 115. It should be noted that, the simulation object has description information of the object, and the description information may include whether the object is transparent. In this case, whether the object has a transparent feature may be determined based on the description information of the object.

The dynamic object complexity level indicates a quantity of dynamic objects in an actual environment corresponding to a simulation environment that needs to be constructed. A higher level indicates a larger quantity of actively dynamic objects, more blocked areas, and more complex reconstruction of the simulation environment. Therefore, different simulation environment reconstruction methods may be selected based on the dynamic object complexity level, to reduce a difference between the constructed simulation scenario and a real scenario. For example, in a scenario with a larger quantity of dynamic objects, for example, a crossroad, an image perceived by a camera may be mainly used, and laser point cloud data collected by a sensor such as a laser radar that perceives an environment in a laser manner may be used as a supplement, to implement simulation environment reconstruction. For example, the dynamic object complexity level may be classified into three levels, for example, simple, medium, and complex. For example, the dynamic object complexity level may be classified into five levels, for example, very simple, simple, medium, complex, and very complex.

In addition, in an actual application, the laser point cloud data collected by the sensor such as the laser radar that perceives the environment in the data warehouse 111 in the laser manner may be processed based on the object with the transparent feature, a proper simulation scenario reconstruction method is selected based on the dynamic object complexity level, different weights are assigned to different sensors, and a proper feature extraction method is selected based on the weights of different sensors and the feature complexity level. In this way, feature extraction and fusion are performed on the data collected by different sensors, and a position, a color, a texture, and the like of the object surface in the real environment are analyzed, to simulate the real environment and reduce the difference between the simulation environment and the real environment. Herein, selecting a proper feature extraction method based on the weights of different sensors and the feature complexity level, to perform feature extraction and fusion on the data collected by different sensors may be understood as selecting a proper feature extraction method based on the feature complexity level, to perform feature extraction on the data collected by different sensors, and analyze the position, the color, the texture, and the like of the object surface in the real scenario; then the features extracted from the data collected by different sensors are fused based on the weights of different sensors, to obtain the position, the color, the texture, and the like that can accurately reflect the object surface in the real scenario. In this way, the simulation of the real environment is implemented.

Step 303: The terminal device 300 sends the identifier of the target simulation environment and the identifier of the target simulation device to the cloud server cluster 100.

Step 304: The cloud server cluster 100 provides a second configuration interface.

Step 305: The terminal device 300 displays the second configuration interface, and obtains an operation performed by a user on the second configuration interface, to obtain a first task instruction.

According to a feasible implementation, the second configuration interface may be a task orchestration page. Specifically, the cloud server cluster 100 may publish the task orchestration page. Correspondingly, the terminal device 300 displays the task orchestration page, so that the user determines the first task instruction by using the task orchestration page and uploads the first task instruction to the cloud server cluster 100. It should be noted that, the first task instruction indicates a task that needs to be completed by the simulation device.

In an example, the user enters a target account and a password on the terminal device 300 to log in to a client of a cloud management platform. Then, the user operates the terminal device 300, the terminal device 300 displays the task orchestration page indicated by the second configuration interface, and the user may orchestrate tasks on the task orchestration page, to obtain the first task instruction.

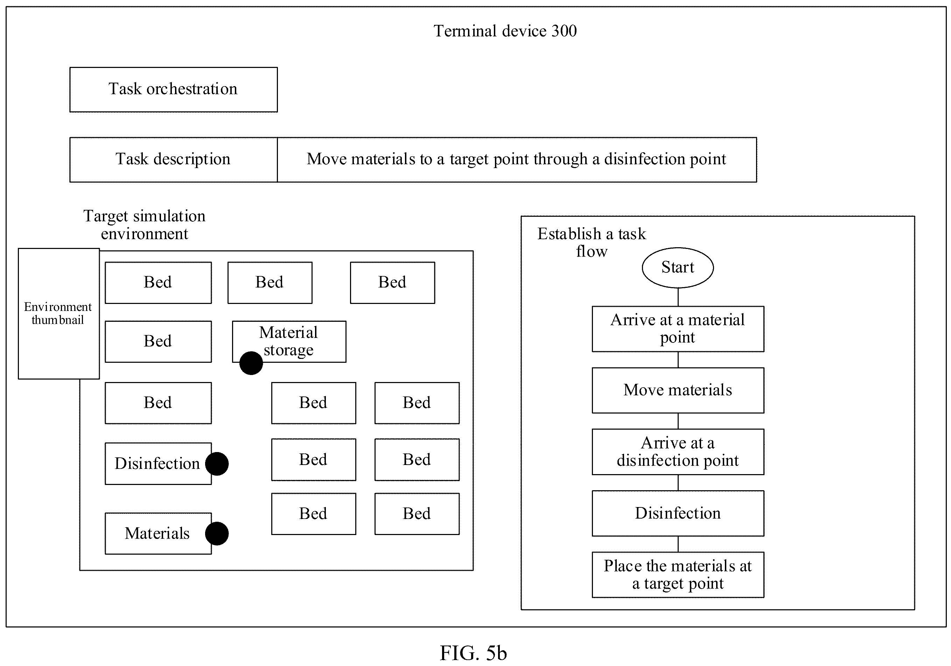

FIG. 5b is a diagram of a task orchestration page according to an embodiment of this application. As shown in FIG. 5b, the task orchestration page includes a task description control, for example, an input box. For example, a task description may be entered on the task orchestration page, for example, moving materials to a target point through a disinfection point. The task orchestration page further includes a task flow creation control. In an actual application, a user can operate the task flow creation control to establish a task flow in a region in which the task flow is established. Specifically, a task starting node may first be established, then a node of a subtask is established, a description of the subtask is added, and a new subtask is continuously added, to finally obtain a task flow. For example, if the materials are moved to the target point through the disinfection point, five subtasks may be established: grabbing materials, arriving at a disinfection point, disinfecting the materials, arriving at a target point, and unloading the materials. It should be noted that, the task orchestration page may further display a thumbnail of the target simulation environment, where the thumbnail is usually a two-dimensional map; and the user may indicate a navigation point in the thumbnail of the target simulation environment. For example, if the materials are moved to the target point through the disinfection point, the material point, the disinfection point, and the target point (a place in which the materials are stored) need to be marked.

Step 306: The terminal device 300 sends the first task instruction to the cloud server cluster 100.

Step 307: The cloud server cluster 100 executes, by using the target simulation device, a task in the target simulation scenario according to the first task instruction and based on the identifier of the target simulation environment and the identifier of the target simulation device, to obtain a first execution result.

In an actual application, a task that needs to be completed may be learned by using the first task instruction and based on semantic recognition, to convert the first task instruction into a simulation instruction, where the simulation instruction is in a computer-readable format. Then, the target simulation device and the target simulation environment are loaded according to the simulation instruction, the identifier of the target simulation environment, and the identifier of the target simulation device; and the simulation device executes the task in the target simulation scenario.

In an actual application, the first configuration interface may further determine an identifier of a target simulator, and load the target simulation environment and the target simulation device in the target simulator. As shown in FIG. 5a, the model configuration page includes a simulator configuration control. In an example, a user clicks the simulator configuration control on the model configuration page, to display a list of simulators, and then the user selects a simulator in the list, so that the first configuration interface may obtain an identifier of a target simulator configured by the user. It should be noted that, there are various types of simulators, and different simulators have different focuses. For example, details of an object surface of a simulator are more real, bringing good visual experience, and details of a three-dimensional model of a simulator are more real. The user may select different simulators to implement simulation.

According to a feasible implementation, the second configuration interface is further configured to obtain a quantity of processes. Correspondingly, the cloud server cluster 100 establishes a process that adapts to the quantity of processes, to concurrently use the target simulation device to execute the task in the target simulation scenario, to ensure task execution efficiency. For example, a task may be divided into a plurality of subtasks, and different subtasks are completed by different processes, to implement parallel processing.

In this solution, the configurations of the simulation device, the simulation environment, and the task are implemented by using the first configuration interface and the second configuration interface. Then, the simulation of the mobile device and the environment in which the mobile device is located may be implemented, and the task is executed in the simulation environment, to reduce difficulty and costs of completing the task by a physical device.

An outdoor open environment in which the mobile device 210 is active is generally large in area, and a generated simulation environment is also large. Loading a complete simulation environment at a time requires a long time and consumes a large quantity of resources. In addition, an operation is not smooth, and rendering the entire simulation environment also takes a long time. This is a great challenge for a current mainstream simulator.

To resolve the foregoing problem, in this embodiment of the present invention, a large model is divided into a plurality of parts by using abundant server resources on a cloud, and the parts are separately loaded by different servers in a distributed manner, to greatly reduce a resource requirement on a single machine.

Correspondingly, based on the embodiment shown in FIG. 3, in this embodiment of the present invention, the first configuration interface may be configured with a quantity of instances. Herein, the instance may include at least one of a physical host (a computing device), a virtual machine, and a container. Correspondingly, the step 307 may include the following content.

The cloud server cluster 100 loads the target simulation environment and the target simulation device on an instance matched with the quantity of instances, so that the target simulation device and the target simulation environment may be loaded by different servers in a distributed manner, to greatly reduce a resource requirement on a single machine.

Further, a local real-time model loading range may be adaptively determined based on a perception range of a simulation sensor on the simulation device, so that loading of an unrelated region in the simulation environment can be avoided to some extent, an overall loading time of the model is reduced, an operation is smoother, and efficient loading and operation of an ultra large-scale model are implemented.

Correspondingly, the step 307 may include the following content.

After loading the target simulation device, the cloud server cluster 100 loads, in a process of executing the task according to the first task instruction, an environment in which the target simulation environment is within the perception range based on the perception range of the simulation sensor on the simulation device.

According to a feasible implementation, after the target simulation device is loaded, a location of the target simulation device in the target simulation environment may be initialized. In a process of executing the task according to the first task instruction, an environment in which the target simulation environment is within the perception range is loaded based on the perception range of the simulation sensor on the simulation device.

According to another feasible implementation, a part of the target simulation environment may be first loaded, then the target simulation device is randomly loaded in the loaded target simulation environment, and then the target simulation environment and the target simulation device within the perception range are loaded based on the perception range of the simulation sensor on the simulation device.

In conclusion, in this solution, by using two manners: loading in a distributed manner and determining the local real-time model loading range in an adaptively manner, an overall loading time of the model is reduced, an operation is smoother, and efficient loading and operation of an ultra large-scale model are implemented.

Based on the embodiment shown in FIG. 3, in this embodiment of the present invention, the target simulation environment includes at least one three-dimensional model and an object parameter carried by the at least one three-dimensional model. Optionally, the first configuration interface may further determine the physical parameter corresponding to the at least one three-dimensional model in the target simulation environment.

In an actual application, as shown in FIG. 5a, the model configuration page indicated by the first configuration interface further includes a physical parameter configuration control of the three-dimensional model in the target simulation environment. In an example, the physical parameter configuration control may display the physical parameter corresponding to the three-dimensional model, so that the first configuration interface may select a target physical parameter from candidate physical parameters of the three-dimensional model. Herein, the three-dimensional model is usually a road surface.

Correspondingly, in the step 307, the cloud server cluster 100 executes the task in the target simulation scenario by using the target simulation device and the physical parameter of the at least one three-dimensional model.

In an actual application, for an indoor scenario, a physical parameter is required when interaction between the target simulation device and the three-dimensional model is performed.

For example, the three-dimensional model is materials. In this case, physical parameters of the materials may include a friction coefficient and a weight of the materials. When the target simulation device needs to grab the materials, a friction force needs to be calculated based on the friction coefficient and the weight of the materials, to determine a force that the target simulation device needs to use to grab the materials.

For example, the three-dimensional model is a road surface, and a physical parameter of the road surface may include a friction coefficient. It is assumed that when the target simulation device needs to perform patrol, and in this case, when the target simulation device needs to move on the road surface, a friction force between the target simulation device and the road surface needs to be calculated based on the friction coefficient of the road surface and a weight of the target simulation device. Then, with reference to a drag coefficient of the target simulation device and preset air information in an indoor environment, a minimum speed required for the target simulation device to move on the road surface may be obtained. Further, if the target simulation device carries materials, a maximum speed at which the materials do not fall needs to be considered.

In this solution, a physical parameter identification technology is used for a real physical parameter that is simulated in the simulation environment, and a difference between the real and the digital is continuously reduced, to provide a reliable simulation environment.

In this embodiment of the present invention, data of a real object in the environment is collected, a simulation object similar to a real object is constructed, and the simulation object library 116 is established, so that a simulation object may be added or reduced in a simulation environment, and a complex simulation environment is generated for robot training, to resolve a problem of a low probability of occurrence of an accident and a small data volume in a real environment.

Correspondingly, based on the embodiment shown in FIG. 3, in this embodiment of the present invention, the step 302 may further include the following content.

The terminal device 300 displays a thumbnail of the target simulation scenario, and obtains the operation performed by the user on the first configuration interface, to obtain an identifier of the target simulation object and a first location of the target simulation object in the target simulation scenario.

In an actual application, as shown in FIG. 5a, the model configuration page indicated by the first configuration interface may further display the thumbnail of the target simulation scenario and a simulation object configuration control in a display region of the environment thumbnail. The simulation object configuration control is used to display a list of thumbnails of the simulation objects in the simulation object library 115. The user may drag the thumbnail to the thumbnails of the target simulation scenario, so that the first configuration interface may obtain the identifier of the target simulation object and the first location of the target simulation object in the target simulation scenario.

Correspondingly, the step 307 specifically includes the following content.

The cloud server cluster 100 loads the target simulation environment, and loads the target simulation object at the first location in the target simulation environment.

It should be noted that, in a process of distributed loading and adaptive loading, if the first location is located within the perception range of the simulation sensor of the target simulation device, in this case, the target simulation object may be loaded at the first location.

It should be noted that, in an actual application, the user may place the target simulation device at a specific location in the target simulation environment, where the location is used as an initial location of the target simulation device. Specifically, as shown in FIG. 5a, the model configuration page displays a thumbnail of the target simulation device in a display region of the device thumbnail, and the user may drag the thumbnail of the target simulation device to the thumbnail of the target simulation scenario, to determine the initial location of the target simulation device in the target simulation device.

Further, in this embodiment of the present invention, a motion behavior of an object in an environment is collected, and the simulation behavior library 116 is established, so that a real motion behavior of the object can be simulated in the simulation environment, and various cases are generated for robot training, to resolve a problem of a low probability of occurrence of a case and a small data volume in a real environment.

Correspondingly, based on the embodiment shown in FIG. 3, in this embodiment of the present invention, the step 302 may further include the following content.

The terminal device 300 displays a thumbnail of the target simulation scenario, and obtains the operation performed by the user on the first configuration interface, to obtain an identifier of the target behavior of the target simulation object.

In an actual application, as shown in FIG. 5a, the model configuration page indicated by the first configuration interface may display the thumbnail of the target simulation scenario (displayed in the display region of the environment thumbnail), a simulation object configuration control, and a simulation behavior configuration control. In an example, the simulation behavior configuration control is configured to display a list of thumbnails of the simulation behaviors of the target simulation object in the simulation behavior library 116. The user may click the thumbnail of the simulation behavior, so that the first configuration interface may obtain the identifier of the target behavior of the target simulation object.

Correspondingly, the step 307 specifically includes the following content.

The cloud server cluster 100 loads the target simulation environment, loads the target simulation object at the first location in the target simulation environment, and controls the target simulation object to move based on the target behavior, to obtain the final target simulation environment.

It should be noted that, in a process of distributed loading and adaptive loading, if the first location is located within the perception range of the simulation sensor of the target simulation device, in this case, the target simulation object may be loaded at the first location, and the target simulation object is controlled to move based on the target behavior.

In this embodiment of the present invention, a motion behavior of weather in an environment is collected, so that a real weather behavior can be simulated in a simulation environment, and various simulation environments are generated for robot training, to resolve a problem of a low probability of occurrence of abnormal weather and a small data volume in a real environment.

Correspondingly, based on the embodiment shown in FIG. 3, in this embodiment of the present invention, after the step 303, the following content may be further included.

The terminal device 300 obtains the operation performed by the user on the first configuration interface, to obtain an identifier of a target weather behavior. Correspondingly, the step 307 specifically includes the following content.

The cloud server cluster 100 loads the target simulation environment and loads the target weather behavior in the target simulation environment.

It should be noted that, the weather behavior may include a wind speed change, a rainfall change, and the like, so that execution results of the target simulation device in different weather conditions may be obtained, and complexity of a real scenario may be adapted.

Generally, if a problem occurs during operation of a robot, for example, equipment damage, the robot needs to be repaired for maintenance and servicing. This method has the following problems.
1. Generally, robot maintenance cannot be completed within a short period of time. A user needs to contact the manufacturer or developer for troubleshooting. This will delay work progress.
2. The repair of the robot may incur some economic costs, especially for sensors such as a laser radar and a high-precision camera that may cost thousands or even tens of thousands of dollars.
3. A faulty robot usually leads to some accidents that may pose a risk to an ambient environment and person. For example, the robot directly collides with a pedestrian or a vehicle.

Based on this, in this embodiment of the present invention, predictive maintenance may be performed on the mobile device 210 by using the simulation device and the simulation environment, to extend a device service life of the mobile device 210 as much as possible, and reduce a risk of an accident.

Based on the embodiment shown in FIG. 3, in this embodiment of the present invention, the task indicated by the first task instruction may be a predictive maintenance task. Correspondingly, the task includes at least one maintenance indicator. The execution result includes a value of the at least one maintenance indicator.

For example, the at least one maintenance indicator includes a temperature threshold of a component in the mobile device, a battery level threshold of the mobile device, and/or a running duration threshold of the mobile device. The component herein may be a central processing unit (central processing unit, CPU for short).

In this case, the step 307 may specifically include the following content.

The cloud server cluster 100 performs simulation testing on the target simulation device in the target simulation environment, and determines the value of the at least one maintenance indicator of the target simulation device.

Further, the cloud server cluster 100 may receive running information sent by the target device corresponding to the target simulation device; determine a loss status of the target device based on motion information and the first execution result; and give an alarm when the loss is high.

It should be noted that, in a scenario of the predictive maintenance task, the user may configure a plurality of target simulation environments. Subsequently, the simulation testing is performed on the target simulation device in the plurality of target simulation environments, to determine the value of the at least one maintenance indicator, so that a loss analysis on the mobile device 210 can be performed more accurately.

Herein, the running information of the target device may include a battery level, a CPU temperature, and/or total running duration, and the like. In this case, the loss may be determined by using one maintenance indicator, or the loss may be determined by using a plurality of maintenance indicators.

It should be noted that, when the loss is determined by using the CPU temperature or the battery level, the CPU temperature in the running information may be compared with the CPU temperature threshold. For example, a ratio of the CPU temperature in the running information to the CPU temperature threshold may be used as the loss. Once the CPU temperature in the running information is close to the CPU temperature threshold, an alarm is given. The battery level and the running duration are similar, and details are not described again.

According to this embodiment of the present invention, a skill training and testing of the simulation device may be implemented, and motion of the simulation device needs to simulate a dynamics parameter of a joint in the simulation device, to ensure that the skill training and testing of the simulation device may be implemented. In an actual application, the dynamics parameter is required when the task of joint motion in the target simulation device is involved. For example, the target simulation device needs to grab an object, dance, greet, mop the ground, spray disinfectant, unload goods, and move a stone.

On the basis embodiment shown in FIG. 3, in this embodiment of the present invention, the target simulation device includes at least one joint, and the first configuration interface may further determine a dynamics parameter corresponding to the at least one joint in the target simulation device.

In an actual application, as shown in FIG. 5a, the model configuration page indicated by the first configuration interface may further include a dynamics parameter configuration control of the target simulation device. In an example, the dynamics parameter configuration control may display a plurality of sets of dynamics parameters of the target simulation device, so that the first configuration interface may select a dynamics parameter from the plurality of candidate sets of dynamics parameters of the target simulation device. Herein, each set of dynamics parameters includes dynamics parameters of all joints in the target simulation device.

Optionally, the user does not need to configure the dynamics parameter of the at least one joint in the target simulation device, but directly uses a default dynamics parameter.

Correspondingly, in the step 307, the cloud server cluster 100 controls, by using the dynamics parameter of the at least one joint in the target simulation device, the target simulation device to execute the task in the target simulation environment.

It should be noted that, a force required for joint motion may be controlled by using the dynamics parameter of the joint in the target simulation device, to implement joint motion of the target simulation device, so that the target simulation device may complete various actions, such as dancing, greeting, walking, and moving.

For example, it is assumed that the target simulation device is a robot, and the task is to cross a soil pile. When executing the task of crossing the soil pile, the cloud server cluster 100 may set a plurality of heights of lifting feet and a lifting speed corresponding to each height. Then, how to control joint motion when the robot lifts the feet may be determined based on a dynamics parameter of a joint required when the robot lifts the feet. Then, simulation testing may be performed on each height and the lifting speed corresponding to each height, to check whether the robot crosses the soil pile.

According to a feasible implementation, the task indicated by the first task instruction includes a plurality of skills. The skills indicate activities that can be implemented by the mobile device 210. Correspondingly, the first execution result includes a skill implementation policy of each of the plurality of skills. In an actual application, the target device corresponding to the target simulation device executes the skill implementation policy to implement the skill. In one example, the plurality of skills include navigation, obstacle avoidance, shooting, dancing, greeting, mopping the ground, spraying disinfectant, unloading goods, grabbing goods, moving stones, crossing soil piles, and the like.

In an example, if the plurality of skills include navigation, the skill implementation policy includes a motion trajectory. In other words, the execution result includes the motion trajectory. Optionally, the cloud server cluster 100 may further display the motion trajectory. It should be noted that, when the skill is navigation, a plurality of task points need to be marked in this case. The task points include a start point and an end point. In some possible scenarios, there are a plurality of task points between the start point and the end point. It should be noted that, the task points may be associated with one or more skills. That is, the skills need to be completed at the task points. The skills at the task points may be shooting, dancing, greeting, unloading, grabbing goods, moving stones, and the like. For example, the task indicated by the first task instruction includes N skills and M task points. It is assumed that there are N skills, the N skills include navigation and (N-1) other skills, and the (N-1) other skills are associated with the M task points. For example, as shown in FIG. 5b, the task orchestration page may further display a thumbnail of the target simulation environment, and this is usually a two-dimensional map. The user may indicate a plurality of task points in the thumbnail of the target simulation environment, for example, a material point, a disinfection point, and a target point (a place in which the materials are stored). Herein, the material point may be a start point, the target point may be an end point, a skill associated with the material point is to grab the materials, a skill associated with the disinfection point is to disinfect the materials, and a skill associated with the target point is to unload the materials.

It should be noted that, in an actual application, the task indicated by the first task instruction needs to be flexibly increased with reference to an actual situation in which the target simulation device executes the task in the target simulation environment, and a new skill may be continuously added. For example, the first task instruction is to move the materials to the target point through the disinfection point. It is assumed that there is a moving object in the target simulation environment, and the target simulation device encounters the object when executing the task. In this case, a new skill of obstacle avoidance may be added. For another example, there is a soil pile in the target simulation environment, and the target simulation device encounters the soil pile when executing the task. In this case, a new skill of crossing the soil pile may be added.

In a possible case, the skill implementation policy in the first execution result is a policy with better performance. For example, it is assumed that the target simulation device is a robot, and the task is to cross a soil pile. When executing the task of crossing the soil pile, the cloud server cluster 100 may set a plurality of heights of lifting feet and a lifting speed corresponding to each height. Then, simulation testing may be performed on each height and the lifting speed corresponding to each height, to check whether the robot crosses the soil pile. Then whether the robot successfully crosses the soil pile, energy consumption, a consumed time, and smoothness of an action at each height and the lifting speed corresponding to each height may be analyzed. Finally, a height and a lifting speed corresponding to each height with a successful crossing, low energy consumption, a low consumed time, and a smoother action are selected.

As shown in FIG. 3, on the basis of the step 301 to the step 307 shown in FIG. 3, this embodiment of the present invention may further include at least the following step.

Step 308: The cloud server cluster 100 delivers the first execution result to the target device corresponding to the target simulation device.

In an actual application, the cloud server cluster 100 may deliver the first execution result to the target device corresponding to the target simulation device, that is, a real device, so that the target device may execute the task based on the first execution result. It should be noted that, the target device is the mobile device 210.

For example, it is assumed that the task is to move the materials to the target point through the disinfection point. The target device may operate based on the motion trajectory in the execution result, move the materials when arriving at the material point, move the moved materials to the disinfection point for disinfection, move the disinfected materials to the target point, and finally place the disinfected materials to the target point.

In a possible case, the skill implementation policy in the first execution result is a policy that may implement a skill. To meet a user requirement, the user may determine the skill implementation policy required for implementing the skill. To facilitate decision-making of the user, the first execution result further includes a task execution status. The task execution status indicates an execution status when the target simulation device executes the task based on the skill implementation policy, for example, an execution time, resource consumption, and whether the target device is stable during the implementation of the skill.

As shown in FIG. 3, on the basis of the step 301 to the step 307 shown in FIG. 3, this embodiment of the present invention may further include at least the following step.

Step 309: The cloud server cluster 100 sends the task execution status in the first execution result to the terminal device 300.

In an example, the cloud server cluster 100 may send the skill implementation policy to the target device, and receive the execution status that is of executing the skill implementation policy by the target device and that is sent by the target device.

In an example, the cloud server cluster 100 may control the target simulation device to implement the skill in the target simulation environment based on the skill implementation policy, to obtain the execution status.

Then, execution statuses of all skill implementation policies in the first execution result are collected, to obtain the task execution status.

Step 310: The terminal device 300 displays the task execution status, and determines a task deployment policy.

According to a feasible implementation, the terminal device 300 may display the task execution status. To facilitate decision-making of the user on skill deployment, the task execution status may further include a thumbnail video when the target simulation device executes each skill implementation policy. Correspondingly, the terminal device 300 may further display the thumbnail video when the target simulation device executes the skill implementation policy, to facilitate decision-making of the user.

Herein, the task deployment policy includes an identifier corresponding to each of the plurality of skills in the task execution status, a deployment policy, and an identifier of a target skill implementation policy.

The deployment policy may be deployment on the target device, deployment on the cloud server cluster 100, or self-adaptive decision-making. To be specific, it may be determined, with reference to a resource status of the target device, whether the deployment policy is executed by the target device or the cloud server cluster 100. In an actual application, after learning the execution statuses of the plurality of different skills, the user may determine whether the skills are deployed on the cloud server cluster 100, or deployed on the target device, or are adaptively determined.

For any skill, the skill in the first execution result may have a plurality of skill implementation policies. In this case, the user may select a skill implementation policy with better performance as the target skill implementation policy of the skill. Further, if there are a plurality of target skill implementation policies, that is, the user selects a plurality of target skill implementation policies, the task deployment policy further includes an execution sequence of the plurality of target skill implementation policies of the skill, to ensure skill implementation in an actual application process.

Step 311: The terminal device 300 sends the task deployment policy to the cloud server cluster 100.

Step 312: The cloud server cluster 100 determines a task execution policy based on the task deployment policy.

Herein, the task execution policy indicates a deployment policy and a target skill implementation policy of each of the plurality of skills. When there are a plurality of target skill implementation policies, the execution sequence of the target skill implementation policies is further included.

During specific implementation, the identifier of the skill implementation policy in the task deployment policy is replaced with the skill implementation policy in the first execution result, to obtain the task execution policy.

Step 313: The cloud server cluster 100 delivers the task execution policy to the target device.

In an actual application, the cloud server cluster 100 may deliver the task execution policy to the target device corresponding to the target simulation device, that is, a real device, so that the target device may execute the task based on the task execution policy.

In this solution, the user may predict an execution time and execution effects of a related skill during the task execution, to provide reference for workload planning and allocation and ensure user experience.

In this embodiment of the present invention, real-time interaction between the mobile device 210 and the simulation device and the simulation environment may be implemented, to reduce a risk of an accident occurring on the mobile device 210.

According to a feasible implementation, the real-time interaction may be a pose synchronization. The task indicated by the first task instruction may be interactive positioning.

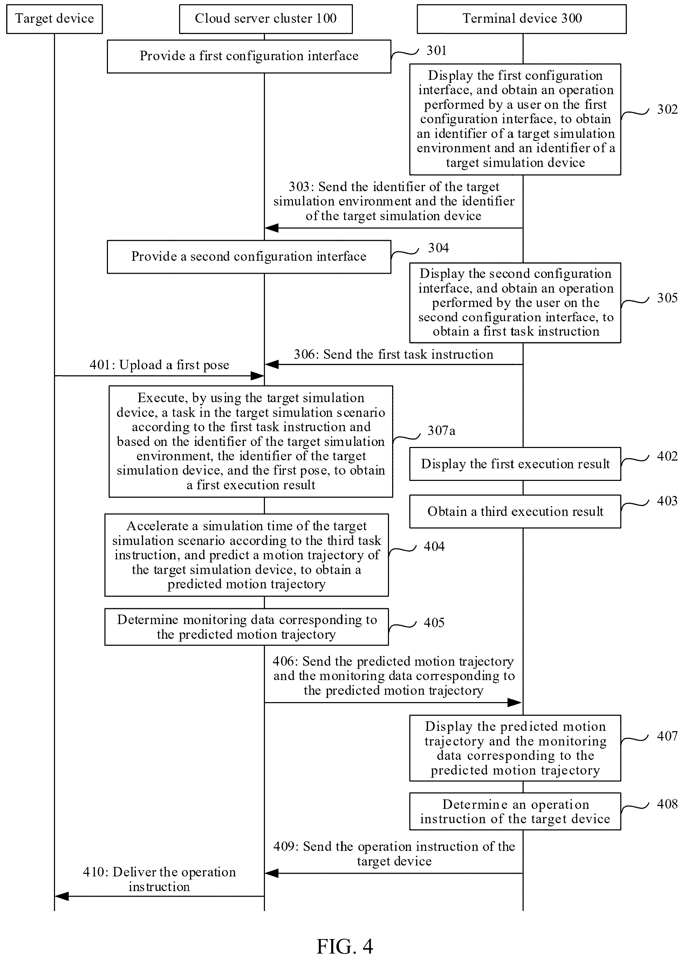

As shown in FIG. 4, before the step 307 shown in FIG. 3, this embodiment of the present invention further includes the following step.

Step 401: The terminal device 300 uploads a first pose.

Correspondingly, the step 307 may specifically include the following content.

Step 307a: The cloud server cluster 100 executes, by using the target simulation device, the task in the target simulation scenario according to the first task instruction and based on the identifier of the target simulation environment, the identifier of the target simulation device, and the first pose, to obtain a first execution result.

Specifically, the cloud server cluster 100 obtains the first pose of the target device corresponding to the target simulation device, and updates a pose of the target simulation device in the target simulation environment based on the first pose. Correspondingly, the first execution result is an updated target simulation environment and an updated target simulation device.

Considering that there is a delay in uploading pose data collected by the mobile device 210 to the cloud server cluster 100, when the cloud server cluster 100 processes the pose data, a pose of the mobile device 210 in reality may have changed. To ensure synchronization with the pose of the mobile device 120 in reality, a real pose of the mobile device 210 in reality may be predicted based on the first pose and simulated acceleration duration.

Optionally, the second configuration interface may further upload the acceleration duration. In this case, the cloud server cluster 100 may update the pose of the target simulation device in the simulation scenario based on the first pose and the acceleration duration. Herein, the acceleration duration may be manually entered by the user.

Optionally, the second configuration interface may further indicate to use default acceleration duration. In this case, the cloud server cluster 100 may calculate a communication delay between the cloud server cluster 100 and the mobile device 210, and use the communication delay as the default acceleration duration. Correspondingly, the cloud server cluster 100 may update the pose of the target simulation device in the simulation scenario based on the first pose and the default acceleration duration.

Further, on the basis of the step 307a, the method further includes at least the following step.

Step 402: The terminal device 300 displays the first execution result.

The cloud server cluster 100 displays the target simulation device, the target simulation scenario, and a fourth configuration interface, where the fourth configuration interface may be a semantic display interface of the target simulation environment, a geometric update interface of the target simulation environment, or a physical parameter update interface of the target simulation environment. In an actual application, the terminal device 300 also displays the target simulation device, the target simulation scenario, and the fourth configuration interface. The user may perform an operation on the fourth configuration interface by using the terminal device 300. Correspondingly, the cloud server cluster 100 may implement a semantic display, a geometric update, and a physical parameter update of the target simulation environment based on information provided by the fourth configuration interface. Herein, the physical parameter update not only includes an update of a physical parameter of a simulation object, but also may include an update of a physical parameter of weather. In addition, if the dynamics parameter of the target simulation device may be updated, the fourth configuration interface may further include a dynamics parameter update interface of the target simulation device.

It should be noted that, subsequently, the cloud server cluster 100 may obtain a second pose of the target device corresponding to the target simulation device, and update, based on the first pose and the second pose, the pose of the target simulation device in the target simulation environment and motion trajectories of the first pose and the second pose. In this way, real-time pose update is implemented.

Step 403: The terminal device 300 obtains a third task instruction.

It should be noted that, a perception range of a sensor of the mobile device 210 is limited, and a potentially dangerous action (for example, a downhill) or a moving obstacle at a surveillance blind spot may not be perceived. In this case, the mobile device 210 has a greater risk, and the risk needs to be avoided. In this case, the subsequent motion of the mobile device 210 may be predicted and evaluated, to control the operation of the robot to avoid the risk.

Correspondingly, the task indicated by the third task instruction is a prediction task. In an example, the fourth configuration interface may further include a prediction interface. In an actual application, the terminal device 300 displays the prediction interface, and the user may perform an operation on the prediction interface and set information such as prediction duration by using the terminal device 300. Correspondingly, the cloud server cluster 100 may implement motion trajectory prediction based on information provided by the prediction interface.

Step 404: The cloud server cluster 100 accelerates a simulation time of the target simulation scenario according to the third task instruction, and predicts a motion trajectory of the target simulation device, to obtain a predicted motion trajectory.

In some possible scenarios, there may be some moving objects in a fixed region in the target simulation scenario, and the moving objects may be located at a surveillance blind spot of the mobile device. In this case, a risk may be perceived in advance through simulation prediction, to provide a basis for subsequent risk avoidance.

In some possible scenarios, there may be some road sections that change dramatically in the target simulation scenario, for example, an uphill road section, a downhill road section, and a road section with a large ground fluctuation. For the road sections, a risk of the mobile device 210 is increased. In this case, a risk may be perceived in advance through simulation prediction, to provide a basis for subsequent risk avoidance.

Step 405: The cloud server cluster 100 determines monitoring data corresponding to the predicted motion trajectory.

It should be noted that, in some possible scenarios, there may be some moving objects in a fixed region in the target simulation scenario, and the moving objects may be located at a surveillance blind spot of the mobile device. In this case, a risk may be perceived in advance by using monitoring data, to provide a basis for subsequent risk avoidance.

It should be noted that, the monitoring data may be collected by the edge device 200. For example, for a plurality of robots running in a campus and surveillance devices in the campus, the monitoring data may be comprehensively determined by combining data collected by the plurality of robots running in the campus and data collected by the surveillance devices.

Step 406: The cloud server cluster 100 sends the predicted motion trajectory and the monitoring data corresponding to the predicted motion trajectory to the terminal device 300.

Step 407: The terminal device 300 displays the predicted motion trajectory and the monitoring data corresponding to the predicted motion trajectory.

In an actual application, the user may analyze, with reference to the predicted motion trajectory and the monitoring data corresponding to the predicted motion trajectory, whether there is a potential moving obstacle in a blind spot of the mobile device 210. If it is determined that there is a risk of collision, the user is prompted to deliver a deceleration or stop instruction in advance to avoid the collision.

Step 408: The terminal device 300 determines an operation instruction of the target device.

In an actual application, the operation instruction such as acceleration, deceleration, or stop may be delivered to the target simulation device, to control the mobile device 210 to avoid a risk.

Step 409: The terminal device 300 sends the operation instruction of the target device to the cloud server cluster 100.

The cloud server cluster 100 delivers the operation instruction on the target simulation device to the target device, so that the target device performs an operation based on the operation instruction.

In this solution, in an aspect, a simulation time is accelerated, so that a pose of the mobile device in a real environment and a pose of the mobile device in a simulation environment may be synchronized. In another aspect, abundant computing resources on the cloud are used to predict the motion trajectory of the simulation device in the simulation environment to avoid a potential risk.

According to a feasible implementation, the real-time interaction may be an edge task uploaded by the mobile device 210 to the cloud server cluster 100 in an actual running process.

As shown in FIG. 3, in this embodiment of the present invention, in the actual running process of the mobile device 210, the following steps may be further included.

Step 314: The target device corresponding to the target simulation device sends a second task instruction and task data to the cloud server cluster 100.

Step 315: The cloud server cluster 100 processes the task data according to the second task instruction to execute the task, to obtain a second execution result.

It should be noted that, a real scenario is complex. The simulation environment constructed in this embodiment of the present invention generally considers only an object that almost does not change in the environment. Therefore, for a task that has a higher real-time requirement: real-time obstacle avoidance and local path planning, the task needs to be deployed on a body of the mobile device 210 for execution. Currently, with use of a large-scale map and introduction of an artificial intelligence model, an increasing quantity of resources of the body of the mobile device 210 are consumed, and consequently, the resources of the body of the mobile device 210 are insufficient. Generally, after performing some necessary tasks, the mobile device 210 may have no extra resources to execute a task that consumes a large quantity of resources. In this embodiment of the present invention, to resolve the problem, a task that consumes a large quantity of resources of the body of the mobile device 210 may be executed by using the cloud server cluster 100.

According to a feasible implementation, the task indicated by the second task instruction may be content recognition. In this case, the task data may be data collected by the sensor. Optionally, the content that needs to be recognized for the content recognition may be voiceprint recognition, voice recognition, and gesture recognition.

According to a feasible implementation, resources consumed by the task indicated by the second task instruction are greater than a specified resource consumption threshold. In an actual application, the target device corresponding to the target simulation device may monitor consumed resources for executing an unnecessary task in real time, and when the consumed resources are greater than the specified resource consumption threshold, the second task instruction of the task may be uploaded to the cloud server cluster 100. Herein, the unnecessary task may be understood as a task with a low real-time requirement, for example, a task other than real-time obstacle avoidance and local path planning.

According to a feasible implementation, the task indicated by the second task instruction may be delivery of a local map.

In this embodiment of the present invention, a local map required for current running of the robot is further adaptively determined based on a perception range of a sensor of the robot, and is sent to the robot from the cloud, to avoid resource consumption caused by large-scale map deployment on the body of the robot. Specifically, the cloud server cluster 100 adaptively determines, based on the perception range of the sensor of the mobile device 210, a local map required for current running of the mobile device 210, and then delivers the local map to the mobile device 210, to avoid resource consumption caused by large-scale map deployment on the body of the mobile device 210.

It should be noted that, on the basis of determining the local map, the target device corresponding to the target simulation device only needs to pay attention to a moving obstacle in the environment, so that resource consumption may be reduced to some extent.

In an example, the task data may be data collected by a sensor of the target device corresponding to the target simulation device (where the task data may indicate a maximum region that can be perceived by the target device). In this case, the cloud server cluster 100 receives the task data sent by the target device corresponding to the target simulation device, and performs matching based on the task data and the target simulation environment, to determine a local region. Then, a local map of the local region in the target simulation scenario may be determined.

In an example, if a location of the target simulation device in the cloud server cluster 100 in the target simulation environment adapts to a location of a device in reality, the local map of the target device corresponding to the target simulation device may be determined based on the perception range of a current simulation sensor of the target simulation device, and the local map is delivered to the target device corresponding to the target simulation device. No task data is required in this manner.

Step 316: The cloud server cluster 100 delivers the second execution result to the target device.

In this solution, the mobile device may upload a task that consumes a large quantity of resources or a task that is difficult to execute to the cloud. After processing the task, the cloud platform returns a result to the edge mobile device, to reduce a requirement on hardware of the mobile device. In addition, cloud resources are flexible and may be used by the user on demand, to further reduce economic costs.

The following describes a specific application of a simulation training method provided in this embodiment of the present invention with reference to a specific scenario. The following uses an example in which the mobile device 210 is a robot for descriptions.

Scenario 1: The robot performs campus patrol. In a conventional method, a map for the campus is established, to obtain a two-dimensional grid map or a three-dimensional point cloud map, task points are marked on the map, and a task is delivered to the robot. The robot develops and tests a navigation skill in a real environment or a simulation world in advance, and then performs navigation patrol based on the map.

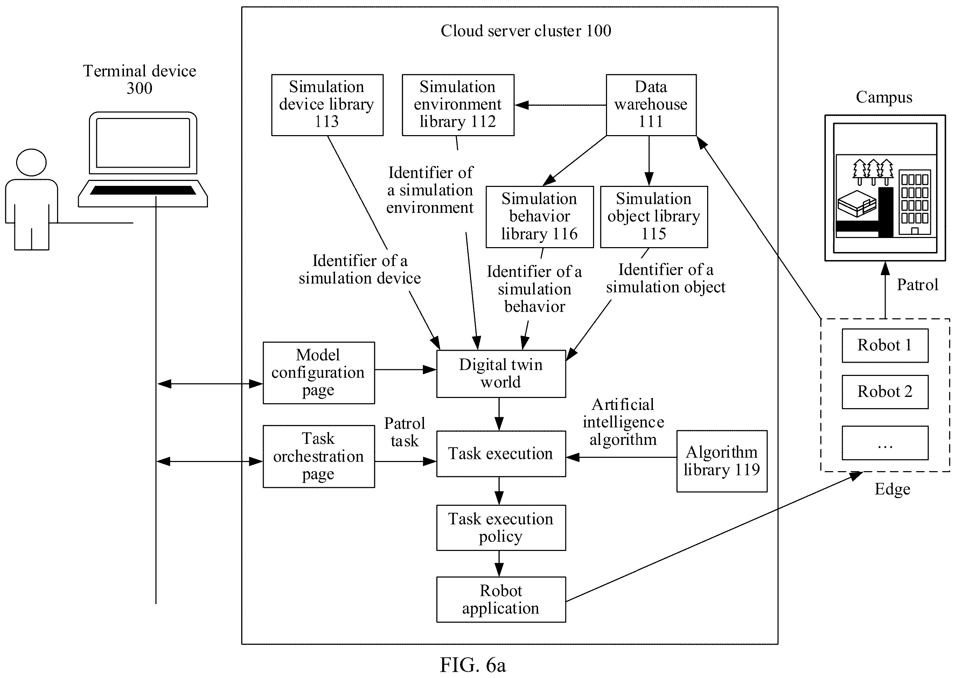

In this embodiment of the present invention, a simulation environment and a simulation device (which may be collectively referred to as a digital twin world) are established, so that the robot can efficiently perform skill training, to complete a campus patrol task. The following describes a training process of the patrol task with reference to the foregoing content and FIG. 6a.

A1: A plurality of robots work together to collect multi-source heterogeneous data such as laser point cloud data, visual images, speeds of the robots, models of the robots, and structural data of the robots in the campus, and upload the data to the cloud server cluster 100. After performing denoising processing, the cloud server cluster 100 stores the data in the data warehouse 111.

A2: The cloud server cluster 100 performs spatial-temporal alignment processing on the data such as the point cloud data, the videos, and the images in the data warehouse 111, performs SLAM based on the laser point cloud data, generates a point cloud model, performs grid and texture reconstruction with reference to the image data, generates a simulation environment of the campus, and adds the simulation environment to the simulation environment library 112. In addition, the cloud server cluster 100 may further generate a simulation object of an object in the campus, and add the simulation object to the simulation object library 115. Description information of the object in the point cloud data and the image data is extracted and stored in the semantic database 118, and a semantic map of the simulation environment is obtained based on matching between the object in the semantic database 118 and the description information of the three-dimensional model in the simulation environment. The simulation environment and the robot model are used as a digital twin world.

A3: The cloud server cluster 100 performs, based on an algorithm in the algorithm library 119, an analysis on dynamics identification, a drag, and an interaction force on collected motion data of the robot and environment data. In this case, a dynamics parameter of each joint in the robot may be obtained, so that the simulation device is closer to a real robot; and physical parameters such as a friction coefficient and a drag coefficient of the three-dimensional model in the simulation environment may be obtained, so that physical parameters of the simulation object in the simulation environment and/or the weather of the simulation environment that are obtained in the previous step are similar to those in reality, to further reduce a difference between the simulation environment and the real environment.

A4: The cloud server cluster 100 extracts a behavior segment of a moving object based on collected video data, collects statistics about the behavior segment, and generates behavior patterns, to obtain a behavior pattern library 116; and then performs modeling based on the behavior patterns in the behavior pattern library, to obtain the simulation behavior library 116, to simulate a real object behavior and a weather behavior, and generate different simulation environments for robot training, to improve a processing capability of the robot to cope with a complex environment in a real world.

A5: A user performs an operation on a model configuration page (the foregoing first configuration interface) provided by the cloud server cluster 100 by using the terminal device 300, to determine an identifier of a simulation device and an identifier of a simulation environment, and may determine identifiers of some simulation objects newly added in the simulation environment, identifiers of simulation behaviors of the simulation objects, and identifiers of simulation weather behaviors.

In some possible implementations, the identifier of the simulation device may be determined based on a robot model and a structure parameter of the robot. In this case, the cloud server cluster 100 may match a simulation device in the simulation device library 113 based on the robot model and the structure parameter of the robot, and select a closest simulation device as the robot model.

A6: The cloud server cluster 100 constructs a data twin world based on the identifier provided by the model configuration page (the foregoing first configuration interface).

Optionally, the data twin world may be obtained by performing segmentation and distributed loading on the simulation device, the simulation environment, the simulation object, the dynamic simulation object, and the simulation weather behavior. This can reduce a loading time of an entire model and make simulation smoother.

A7: The user performs, by using the terminal device 300, an operation on a task orchestration page (the foregoing second configuration interface) provided by the cloud server cluster 100, to determine a patrol task.

A8: The cloud server cluster 100 executes, in the digital twin world constructed in A6 by using the artificial intelligence algorithm in the algorithm library 119, the patrol task uploaded on the task orchestration page (the second configuration interface), to obtain a first execution result.

Herein, the cloud server cluster 100 forms a closed-loop simulation training system of perception, decision-making, planning, and control, to improve efficiency of robot skill development and testing.

A9: The cloud server cluster 100 packages application deployment by using the first execution result as a task execution policy, and delivers the packaged robot applications to a plurality of edge robots. The robot application, or referred to as a native robot application, is an application designed and developed for a robot platform and a scenario.

Herein, the task execution policy may be a planned motion path.

A10: The plurality of edge robots run the received robot applications and perform campus patrol.

A11: The multi-source heterogeneous data collected by each of the plurality of edge robots in a patrol process is uploaded to the cloud server cluster 100 again. The cloud server cluster 100 updates an existing simulation environment, performs grid and texture reconstruction on a changed part, and updates the semantic database.

In this solution, the simulation environment is established by collecting the multi-source data of the sensors in the campus, and the simulation environment is continuously updated. In addition, the physical parameters that align with the real environment are assigned to the simulation environment, to further reduce the difference between the simulation environment and the real environment, and provide a precise navigation map for the robot. In addition, the generated digital twin world is used to enable closed-loop simulation, to reduce time and economic costs of robot field testing. By using an edge-cloud synergy technology, utilization efficiency of local resources of the robot and cloud resources are greatly improved, and the development and the testing of robot skills are accelerated.

Scenario 2: In some special places, such as an epidemic quarantine area or a cabin hospital, manual task execution may bring an infection risk. In addition, various disinfection and epidemic prevention processes need to be performed, causing great time and economic costs. Therefore, a robot may be used to replace a person to execute a task. Different from outdoor campus patrol, the cabin hospital has complex environments, and it is more difficult for the robot to execute a task than that in the conventional patrol, including moving materials, disinfecting the materials in a specified region, unloading the materials at a target point, and isolating interaction with a person in the region. In addition, quality and a completion time of tasks performed by the robot need to be evaluated, to determine a daily delivery volume for materials.

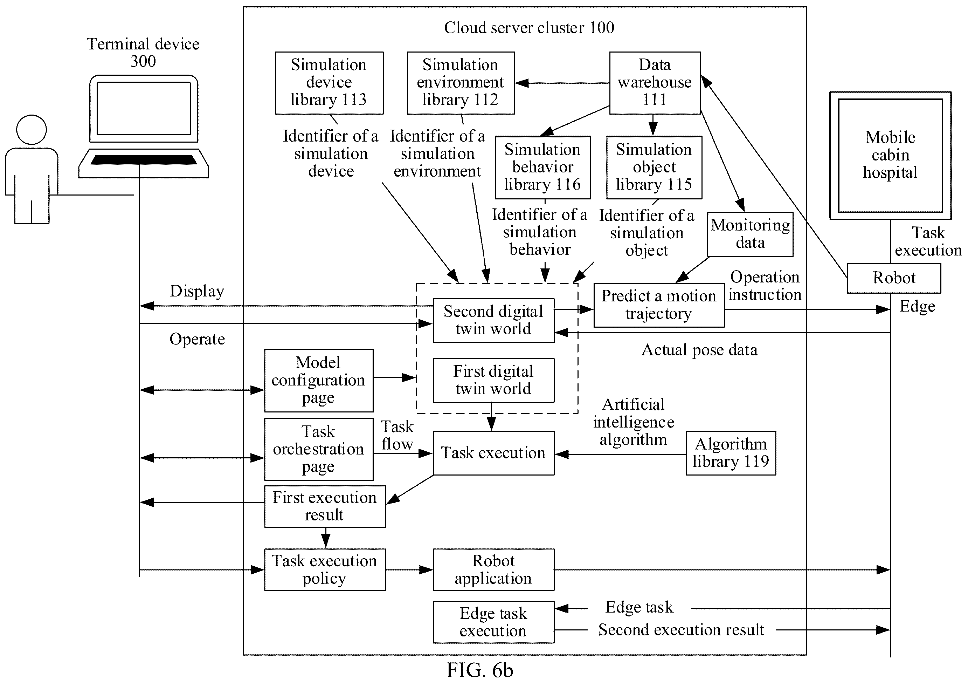

With reference to FIG. 6b and the foregoing content, the following describes a simulation training process in a cabin hospital scenario.

The following describes a specific process with reference to the foregoing content.

B1: The robot collects multi-source heterogeneous data in the cabin hospital, uploads the data to the cloud server cluster 100, and generates a first digital twin world of the cabin hospital based on the process of constructing the digital twin world described in A1 to A6.

It is worth noting that, the first digital twin world is a digital twin world configured for the user to implement simulation training, and various complex environments that are rare in the real world are constructed.

B2: The user performs semantic analysis and splitting on a material disinfection and transportation task by using the terminal device 300, for example, converts a task of "moving materials to a target point through a disinfection point" into a task flow: grabbing the materials, arriving at the disinfection point, disinfecting the materials, arriving at the target point, and unloading the materials.

B3: The user edits, by using the task orchestration page (the foregoing second configuration interface) provided by the cloud server cluster 100, the task flow obtained through performing splitting on the task orchestration page (the foregoing second configuration interface).

For example, in the digital twin world, a start point, a material grabbing point, a disinfection point, and an unloading point are marked.

B4: The cloud server cluster 100 performs, based on the first data twin world determined in B1, simulation training on a plurality of skills in the task flow uploaded on the task orchestration page (the foregoing second configuration interface), to determine the first execution result.

It should be noted that, in an actual application, the cloud server cluster 100 may split tasks of a task flow into a plurality of skills (which cannot be further divided), and perform simulation training on each skill.

Herein, the first execution result may include a plurality of skill implementation policies of each of the plurality of skills.

B5: The cloud server cluster 100 sends a task execution status in the first execution result to the terminal device 100.

B6: The terminal device 300 displays the task execution status, and determines a task deployment policy.

For details, refer to the foregoing descriptions of the step 309 to the step 312, and details are not described again.

B7: The cloud server cluster 100 determines a task execution policy based on the task deployment policy, performs packaging preparation for application deployment based on the task execution policy, and delivers packaged robot applications to the edge robot.

B8: The edge robot runs the received robot applications, disinfects and transports the materials in the cabin hospital, monitors consumed resources and execution difficulty of a task in real time, and uploads the edge task to the cloud server cluster 100 for execution if the task consumes a large quantity of resources or the task is difficult to process.

Herein, the edge task may be a task such as interaction with a person at the isolation point and gesture recognition.

B9: After completing task execution, the cloud server cluster 100 delivers a second execution result to the edge robot.

B10: The cloud server cluster 100 generates a second digital twin world of the cabin hospital based on the foregoing process of constructing the digital twin world described in A1 to A6, and the terminal device 300 displays the second digital twin world.

It should be noted that, the second digital twin world is a digital twin world configured for the user to implement real-time interaction, and is similar to a real environment.

B11: The cloud server cluster 100 continuously updates, by receiving real-time pose data of the edge robot, a pose of a robot model in the second digital twin world determined in B9, to perform synchronization with a pose of a robot in the real world.

In an actual application, the cloud server cluster 100 accelerates a time of the current digital twin world based on actual pose data of the robot, and reduces a delay between the simulation world and the real world, to achieve an objective of a real-time remote operation. For details, refer to the foregoing descriptions of the step 307a.

B12: The cloud server cluster 100 may predict, based on an operation performed by the terminal device 300 on a prediction interface of the second digital twin world, a subsequent motion trajectory of the robot model in the second digital twin world, to obtain a predicted motion trajectory, and determine monitoring data of the cabin hospital corresponding to the predicted motion trajectory. In an example, the cloud server cluster 100 may analyze whether there is a potential moving obstacle in a blind spot of the robot. If it is determined that there is a risk of collision, the cloud server cluster 100 queries the terminal device 300 whether the edge robot is allowed to execute an operation instruction (a deceleration or a stop instruction) to avoid the collision. If the terminal device 300 agrees with the operation instruction, the cloud server cluster 100 may deliver the operation instruction to the edge robot. In an example, the cloud server cluster 100 may send the predicted motion trajectory and the monitoring data of the cabin hospital corresponding to the motion trajectory to the terminal device 300, to analyze whether there is a potential moving obstacle in a blind spot of the robot. If the user determines that there is a risk of collision, the user may upload an operation instruction of the edge robot to the cloud server cluster 100, and the cloud server cluster 100 may deliver the operation instruction to a corresponding edge robot.

In this solution, the robot performs tasks in the cabin hospital, to avoid a virus infection risk caused by manual execution, simplify the disinfection and epidemic prevention process, and reduce the time and economic costs. According to the digital twin world of the cabin hospital established in the present invention, the simulation environment that meets requirements of the real world for robot skill training is provided, to improve development and testing efficiency, and semi-autonomous remote operation by the user on the robot is supported. In the simulation environment, the actual motion status of the robot is simulated, and the motion trajectory of the robot is predicted through the large-scale cloud computing power, to avoid the potential risk and further improve working efficiency.

In conclusion, embodiments of the present invention have the following technical effects.

According to a first aspect, the simulation environment, the simulation object, the simulation behavior, and the like are constructed in the cloud server cluster based on the data collected by the edge device, and various complex simulation environments may be constructed for simulation training and testing, to resolve a problem of a low probability of occurrence of an accident and a small data volume in a real environment.

According to a second aspect, the physical parameter of the simulation object in the simulation environment is identified, and the simulation device with the same physical attributes of a physical mobile device is used in the simulation environment to execute the task, to reduce a difference between task execution in the real environment and task execution in the simulation environment.

According to a third aspect, the closed-loop simulation such as perception, decision-making, planning, and control are supported for skill training and testing. In addition, the multi-source data collected by the physical edge device is fed back to the cloud server cluster for closed-loop simulation for skill training and testing, to implement a dynamic closed-loop and continuously evolving intelligent cloud system.

According to a fourth aspect, pose synchronization between the physical mobile device and the simulation device may be implemented, the subsequent motion trajectory of the simulation device may be predicted, and the predicted motion trajectory and the monitoring data of the motion trajectory is fed back to the user, so that the user may learn a running status of the mobile device, and operate the physical mobile device to avoid a risk, to reduce difficulty and costs of operating the mobile device to complete the task.

According to a fifth aspect, the cloud server cluster may process a task that consumes a large quantity of resources of the mobile device or a task that is difficult to process, to reduce a hardware requirement for the physical mobile device.

According to a sixth aspect, predictive maintenance is performed on the mobile device 210 by using the simulation device and the simulation environment, to extend a device service life of the mobile device 210 as much as possible, and reduce a risk of an accident.

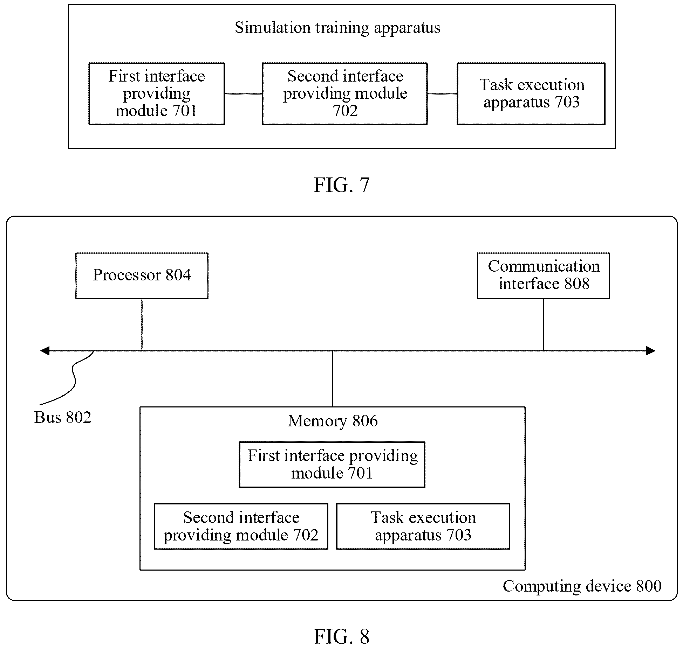

This application further provides a simulation training apparatus. As shown in FIG. 7, the apparatus includes:
a first interface providing module 701, configured to provide a first configuration interface, where the first configuration interface is configured to obtain an identifier of a target environment and an identifier of a target simulation device;
a second interface providing module 702, configured to provide a second configuration interface, where the second configuration interface is configured to obtain a task instruction; and
a task execution module 703, configured to execute, by using the target simulation device, a task according to the task instruction in a simulation scenario, to obtain an execution result.

The first interface providing module 701, the second interface providing module 702, and the task execution module 703 may all be implemented by using software, or may be implemented by using hardware. For example, the following uses the first interface providing module 701 as an example to describe an implementation of the first interface providing module 701. Similarly, for implementations of the second interface providing module 702 and the task execution module 703, reference may be made to the implementation of the first interface providing module 701.

The module is used as an example of a software functional unit, and the first interface providing module 701 may include code running on a computing instance. The computing instance may include at least one of a physical host (a computing device), a virtual machine, and a container. Further, there may be one or more computing instances. For example, the first interface providing module 701 may include code running on a plurality of hosts/virtual machines/containers. It should be noted that, the plurality of hosts/virtual machines/containers used to run the code may be distributed in a same region (region), or may be distributed in different regions. Further, the plurality of hosts/virtual machines/containers used to run the code may be distributed in a same availability zone (availability zone, AZ), or may be distributed in different AZs. Each AZ includes one data center or a plurality of data centers that are geographically close to each other. Generally, one region may include a plurality of AZs.

Similarly, the plurality of hosts/virtual machines/containers used to run the code may be distributed in a same virtual private cloud (virtual private cloud, VPC), or may be distributed in a plurality of VPCs. Generally, one VPC is set in one region. A communication gateway needs to be set in each VPC for communication between two VPCs in a same region or between VPCs in different regions. Interconnection between VPCs is implemented through the communication gateway.

The module is used as an example of a hardware functional unit, and the first interface providing module 701 may include at least one computing device, such as a server. Alternatively, an A module may be a device implemented by using an application-specific integrated circuit (application-specific integrated circuit, ASIC), a programmable logic device (programmable logic device, PLD), or the like. The PLD may be implemented by a complex programmable logic device (complex programmable logic device, CPLD), a field-programmable gate array (field-programmable gate array, FPGA), generic array logic (generic array logic, GAL), or any combination thereof.

A plurality of computing devices included in the first interface providing module 701 may be distributed in a same region, or may be distributed in different regions. The plurality of computing devices included in the first interface providing module 701 may be distributed in a same AZ, or may be distributed in different AZs. Similarly, the plurality of computing devices included in the first interface providing module 701 may be distributed in a same VPC, or may be distributed in a plurality of VPCs. The plurality of computing devices may be any combination of computing devices such as a server, an ASIC, a PLD, a CPLD, an FPGA, and GAL.

It should be noted that, in other embodiments, the first interface providing module 701 may be configured to perform any step in the simulation training method, the second interface providing module 702 may be configured to perform any step in the simulation training method, and the task execution module 703 may be configured to perform any step in the simulation training method. Steps implemented by the first interface providing module 701, the second interface providing module 702, and the task execution module 703 may be specified as required; and the first interface providing module 701, the second interface providing module 702, and the task execution module 703 are used to implement different steps in the simulation training method to implement all functions of the simulation training apparatus.

This application further provides a computing device 800. As shown in FIG. 8, the computing device 800 includes a bus 802, a processor 804, a memory 806, and a communication interface 808. The processor 804, the memory 806, and the communication interface 808 communicate with each other through the bus 802. The computing device 800 may be a server or a terminal device. It should be understood that a quantity of processors and a quantity of memories in the computing device 800 are not limited in this application.

The bus 802 may be a peripheral component interconnect (peripheral component interconnect, PCI) bus, an extended industry standard architecture (extended industry standard architecture, EISA) bus, or the like. The bus may be an address bus, a data bus, a control bus, or the like. For ease of representations, only one line is used to represent the bus in FIG. 3, but this does not mean that there is only one bus or only one type of bus. The bus 804 may include a path for transmitting information between components (for example, the memory 806, the processor 804, and the communication interface 808) of the computing device 800.

The processor 804 may include any one or more of processors such as a central processing unit (central processing unit, CPU), a graphics processing unit (graphics processing unit, GPU), a microprocessor (microprocessor, MP), a digital signal processor (digital signal processor, DSP), or the like.

The memory 806 may include a volatile memory (volatile memory), for example, a random access memory (random access memory, RAM). The processor 804 may further include a non-volatile memory (non-volatile memory), for example, a read-only memory (read-only memory, ROM), a flash memory, a hard disk drive (hard disk drive, HDD), or a solid-state drive (solid-state drive, SSD).

The memory 806 stores executable program code, and the processor 804 executes the executable program code to separately implement functions of the first interface providing module 701, the second interface providing module 702, and the task execution module 703, to implement the simulation training method. That is, the memory 806 stores instructions for performing the simulation training method.

The communication interface 808 uses a transceiver module, for example, but not limited to a network interface card, a transceiver, to implement communication between the computing device 800 and another device or a communication network.

An embodiment of this application further provides a computing device cluster, corresponding to the foregoing cloud server cluster 100. The computing device cluster includes at least one computing device. The computing device may be a server, for example, a central server, an edge server, or a local server in a local data center. In some embodiments, the computing device may alternatively be a terminal device, for example, a desktop computer, a notebook computer, or a smartphone.

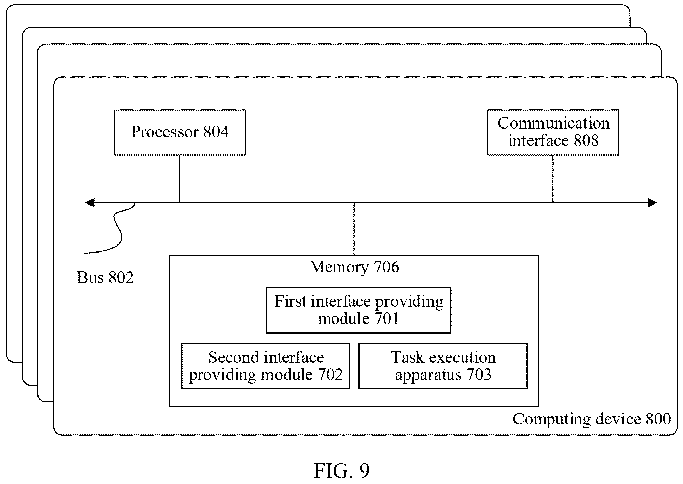

As shown in FIG. 9, the computing device cluster includes at least one computing device 800. The memory 806 in one or more computing devices 800 in the computing device cluster may store same instructions for performing the simulation training method.

In some possible implementations, the memory 806 in the one or more computing devices 800 in the computing device cluster may alternatively separately store some instructions for performing the simulation training method. In other words, a combination of the one or more computing devices 800 may jointly execute instructions for performing the simulation training method.

It should be noted that, the memories 806 in different computing devices 800 in the computing device cluster may store different instructions that are separately for executing some functions of the simulation training apparatus. In other words, instructions stored in the memories 806 in different computing devices 800 may implement functions of one or more of the first interface providing module 701, the second interface providing module 702, and the task execution module 703.

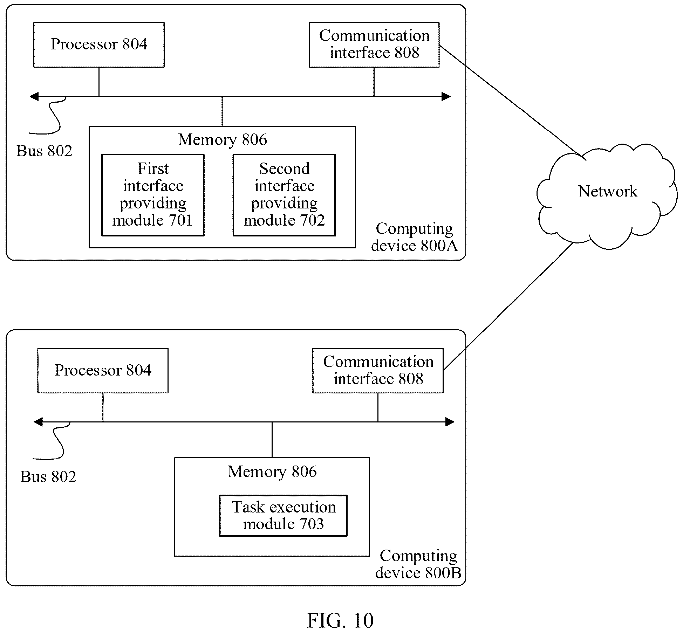

In some possible implementations, the one or more computing devices in the computing device cluster may be connected through a network. The network may be a wide area network, a local area network, or the like. FIG. 10 shows a possible implementation. As shown in FIG. 10, two computing devices 800A and 100B are connected by using a network, specifically, connected to the network through communication interfaces in the computing devices. In this type of possible implementation, the memory 806 in the computing device 800A stores instructions for executing functions of the first interface providing module 701 and the second interface providing module 702. In addition, the memory 806 in the computing device 800B stores instructions for executing a function of the task execution module 703.

In view of a connection manner between the computing device clusters shown in FIG. 10, in the simulation training method provided in this application, a simulation environment and a simulation device need to be loaded by using a large quantity of resources, and simulation training needs to be performed. Therefore, it is considered that a function implemented by the task execution module 703 is performed by the computing device 800B.

It should be understood that functions of the computing device 800A shown in FIG. 10 may alternatively be completed by a plurality of computing devices 800. Similarly, functions of the computing device 800B may alternatively be completed by a plurality of computing devices 800.

An embodiment of this application further provides a computer program product including instructions. The computer program product may be software or a program product that includes the instructions and that can be run on a computing device or be stored in any usable medium. When the computer program product is run on at least one computing device, the at least one computing device is caused to perform the simulation training method.

An embodiment of this application further provides a computer-readable storage medium. The computer-readable storage medium may be any usable medium accessible by a computing device, or a data storage device, such as a data center, including one or more usable media. The usable medium may be a magnetic medium (for example, a floppy disk, a hard disk drive, or a magnetic tape), an optical medium (for example, a DVD), a semiconductor medium (for example, a solid-state drive), or the like. The computer-readable storage medium includes instructions that indicate a computing device to perform a simulation training method.

In the foregoing embodiments, descriptions of each embodiment have respective focuses. For a part that is not described in detail or recorded in an embodiment, refer to related descriptions in another embodiment.

The foregoing describes basic principles of this application with reference to specific embodiments. However, it should be noted that, advantages, benefits, effects, and the like mentioned in this application are merely examples rather than limitations, and it cannot be considered that these advantages, benefits, effects, and the like are mandatory for embodiments of this disclosure. In addition, specific details disclosed above are merely intended for purpose of example and for ease of understanding, but are not intended for limitations. The foregoing details do not limit a case in which this disclosure needs to be implemented by using the foregoing specific details.

Block diagrams of the apparatus, the device, and the system in this disclosure are merely examples, and are not intended to require or imply that connections, arrangements, and configurations need to be performed in a manner shown in the block diagrams. A person skilled in the art will recognize that the component, the apparatus, the device, and the system may be connected, arranged, and configured in any manner. Words such as "include", "contain", and "have" are open words, refer to "including but not limited to", and may be used interchangeably. The terms "or" and "and" used herein refer to the terms "and/or", and may be interchangeably used, unless the context explicitly indicates otherwise. The word "such as" used herein refers to a phrase "such as but not limited to", and may be interchangeably used.

It should be further noted that in the apparatus, the device, and the method disclosed in this disclosure, the components or the steps may be decomposed and/or recombined. The decomposition and/or recombination should be considered as equivalent solutions of this disclosure.

The foregoing descriptions have been provided for the purpose of illustration and descriptions. In addition, the descriptions are not intended to limit embodiments of this disclosure to the form disclosed herein. Although a plurality of example aspects and embodiments have been discussed above, a person skilled in the art will recognize some of their variations, modifications, changes, additions, and sub-combinations.

It may be understood that, various numbers in embodiments of this application are merely used for differentiation for ease of descriptions, and are not used to limit the scope of embodiments of this application.

## Claims

1. A simulation training method, applied to a cloud management platform, wherein the method comprises:
providing a first configuration interface, wherein the first configuration interface is configured to obtain an identifier of a target simulation environment and an identifier of a target simulation device;
providing a second configuration interface, wherein the second configuration interface is configured to obtain a task instruction; and
executing, by using the target simulation device, a task according to the task instruction in the target simulation environment, to obtain an execution result.

2. The method according to claim 1, wherein before obtaining the identifier of a target simulation scenario, the method comprises:
obtaining collected data corresponding to the target simulation environment;
providing a third configuration interface, wherein the third configuration interface is configured to obtain a type parameter of the target simulation environment; and
generating the simulation environment based on the collected data corresponding to the target simulation environment and the type parameter of the target simulation environment.

3. The method according to claim 2, wherein the type parameter comprises one or more of the following:
an indoor scenario, an outdoor scenario, and a weather type.

4. The method according to claims 1 to 3, wherein the target simulation environment comprises at least one three-dimensional model and a physical parameter carried by each of the at least one three-dimensional model, and the executing, by using the target simulation device, a task according to the task instruction in the target simulation environment comprises:
executing, by using the target simulation device and the physical parameter of the at least one three-dimensional model, the task according to the task instruction in the target simulation environment.

5. The method according to claim 4, wherein the physical parameter comprises a friction coefficient and/or a drag coefficient.

6. The method according to any one of claims 1 to 5, wherein the second configuration interface is further configured to obtain a quantity of processes corresponding to the task.

7. The method according to any one of claims 1 to 6, wherein the task comprises a start point and an end point, and the second configuration interface is further configured to obtain the start point and the end point that are set by a user.

8. The method according to any one of claims 1 to 7, wherein obtaining the identifier of the target simulation environment comprises:
the first configuration interface is configured to obtain the identifier of the target simulation environment selected by the user from a plurality of candidate simulation environments; and/or
obtaining the identifier of the simulation device comprises:
the first configuration interface is configured to obtain the identifier of the target simulation device selected by the user from a plurality of candidate simulation devices.

9. The method according to any one of claims 1 to 8, wherein the method further comprises:
delivering the execution result to a target device corresponding to the target simulation device.

10. The method according to any one of claims 1 to 9, wherein the executing, by using the simulation device, a task according to the task instruction in the target simulation environment comprises:
converting the task instruction into a simulation instruction based on semantic recognition, wherein the simulation instruction is in a computer-readable format; and
executing, by using the target simulation device, the task according to the simulation instruction in the target simulation environment.

11. The method according to any one of claims 1 to 10, wherein the execution result comprises a motion trajectory, and the method further comprises displaying the motion trajectory.

12. The method according to any one of claims 1 to 11, wherein the target simulation device comprises at least one joint and a dynamics parameter corresponding to each of the at least one joint, and the executing, by using the target simulation device, a task according to the task instruction in the target simulation environment comprises:
controlling, by using the dynamics parameter of the at least one joint in the target simulation device and according to the task instruction, the target simulation device to execute the task in the target simulation environment.

13. A simulation training apparatus, used in a cloud management platform, wherein the apparatus comprises:
a first interface providing module, configured to provide a first configuration interface, wherein the first configuration interface is configured to obtain an identifier of a target environment and an identifier of a target simulation device;
a second interface providing module, configured to provide a second configuration interface, wherein the second configuration interface is configured to obtain a task instruction; and
a task execution module, configured to execute, by using the target simulation device, a task according to the task instruction in the simulation scenario, to obtain an execution result.

14. A computing device cluster, comprising at least one computing device, wherein each computing device comprises a processor and a memory, wherein
the processor of the at least one computing device is configured to execute instructions stored in the memory of the at least one computing device, so that the computing device cluster is enabled to perform the method according to any one of claims 1 to 12.

15. A computer program product comprising instructions, wherein when the instructions are run by a computing device cluster, the computing device cluster is enabled to perform the method according to any one of claims 1 to 12.

16. A computer-readable storage medium, comprising computer program instructions, wherein when the computer program instructions are run by a computing device cluster, the computing device cluster is enabled to perform the method according to any one of claims 1 to 12.
